# EUROPEAN PATENT APPLICATION

(11) **EP 4 167 302 A1**
(43) Date of publication of application: **19.04.2023**
(21) Application number: 21827112.0
(22) Date of filing: 10.03.2021
(51) Int. Cl.: H01L 31/108, G01J 1/02, H01L 27/144, H01L 27/146

(54) **ELECTROMAGNETIC WAVE DETECTOR AND ELECTROMAGNETIC WAVE DETECTOR ARRAY**

(30) Priority: 15.06.2020 JP 2020102988
(71) Applicant: MITSUBISHI ELECTRIC CORPORATION, Chiyoda-ku Tokyo 100-8310 (JP)
(72) Inventor: SHIMATANI, Masaaki, Tokyo 100-8310 (JP); OGAWA, Shimpei, Tokyo 100-8310 (JP); FUKUSHIMA, Shoichiro, Tokyo 100-8310 (JP); OKUDA, Satoshi, Tokyo 100-8310 (JP)
(74) Representative: Trinks, Ole
(86) International application number: PCT/JP2021/009541
(87) International publication number: WO 2021/256016

(57) **Abstract**

An electromagnetic wave detector includes a semiconductor layer (4), a two-dimensional material layer (1) electrically connected to the semiconductor layer, a first electrode (2a) electrically connected to the two-dimensional material layer without the semiconductor layer interposed therebetween, a second electrode (2b) electrically connected to the two-dimensional material layer with the semiconductor layer (4) interposed therebetween, and a ferroelectric layer (5) in contact with at least a part of the two-dimensional material layer.

## Description

### TECHNICAL FIELD

The present invention relates to an electromagnetic wave detector and an electromagnetic wave detector array.

### BACKGROUND ART

Conventionally, graphene having extremely high mobility, which is an example of a two-dimensional material layer, is known as a material of an electromagnetic wave detection layer used in a next-generation electromagnetic wave detector. The absorptivity of graphene is as low as 2.3 %. For this reason, a method for increasing sensitivity in the electromagnetic wave detector using the graphene has been proposed. For example, US 2015/0243826 A (PTL 1) proposes a detector having the following structure. That is, in the detector of PTL 1, two or more dielectric layers are provided on an n-type semiconductor layer. A graphene layer is formed on the two dielectric layers and on a surface portion of the n-type semiconductor layer located between the two dielectric layers. The graphene layer and the n-type semiconductor layer are joined to form a Schottky junction. A source/drain electrode connected to both ends of the graphene layer is disposed on the dielectric layer. A gate electrode is connected to the n-type semiconductor layer. When voltage is applied between the gate electrode and the source electrode or the drain electrode, the Schottky junction enables an OFF operation.

### CITATION LIST

### PATENT LITERATURE

PTL 1: US 2015/0243826 A

### SUMMARY OF INVENTION

### TECHNICAL PROBLEM

However, in a state where voltage is applied between a gate electrode and a source electrode or a drain electrode, sensitivity of a detector depends on quantum efficiency of a semiconductor layer. Accordingly, sufficient amplification of photocarriers cannot be performed, and it is difficult to increase the sensitivity of the detector.

A main object of the present invention is to provide an electromagnetic wave detector and an electromagnetic wave detector array having higher detection sensitivity than the above detectors.

### SOLUTION TO PROBLEM

An electromagnetic wave detector according to the present invention includes a semiconductor layer, a two-dimensional material layer electrically connected to the semiconductor layer, a first electrode electrically connected to the two-dimensional material layer without the semiconductor layer interposed therebetween, a second electrode electrically connected to the two-dimensional material layer with the semiconductor layer interposed therebetween, and a ferroelectric layer that is in contact with at least a part of the two-dimensional material layer.

### ADVANTAGEOUS EFFECTS OF INVENTION

According to the present invention, an electromagnetic wave detector and an electromagnetic wave detector array having higher detection sensitivity than the above detectors can be provided.

### BRIEF DESCRIPTION OF DRAWINGS

- FIG. 1: is a schematic plan view illustrating an electromagnetic wave detector according to a first embodiment.
- FIG. 2: is a schematic sectional view taken along a line II-II in FIG. 1.
- FIG. 3: is a flowchart illustrating a method for manufacturing the electromagnetic wave detector according to the first embodiment.
- FIG. 4: is a schematic plan view illustrating an electromagnetic wave detector according to a second embodiment.
- FIG. 5: is a schematic sectional view taken along a line V-V in FIG. 4.
- FIG. 6: is a schematic sectional view illustrating a first modification of the electromagnetic wave detector according to the second embodiment.
- FIG. 7: is a schematic sectional view illustrating a second modification of the electromagnetic wave detector according to the second embodiment.
- FIG. 8: is a schematic plan view illustrating an electromagnetic wave detector according to a third embodiment.
- FIG. 9: is a schematic sectional view taken along line IX-IX in FIG. 8.
- FIG. 10: is a schematic plan view illustrating an electromagnetic wave detector according to a fourth embodiment.
- FIG. 11: is a schematic sectional view taken along a line XI-XI in FIG. 10.
- FIG. 12: is a schematic plan view illustrating a first modification of the electromagnetic wave detector according to the fourth embodiment.
- FIG. 13: is a schematic sectional view taken along a line XIII-XIII in FIG. 12.
- FIG. 14: is a schematic plan view illustrating a second modification of the electromagnetic wave detector according to the fourth embodiment.
- FIG. 15: is a schematic sectional view taken along a line XV-XV in FIG. 14.
- FIG. 16: is a schematic sectional view illustrating an electromagnetic wave detector according to a fifth embodiment.
- FIG. 17: is a schematic plan view illustrating a modification of the electromagnetic wave detector according to the fifth embodiment.
- FIG. 18: is a schematic sectional view taken along a line XVIII-XVIII in FIG. 17.
- FIG. 19: is a schematic sectional view illustrating an electromagnetic wave detector according to a seventh embodiment.
- FIG. 20: is a schematic sectional view illustrating an electromagnetic wave detector according to an eighth embodiment.
- FIG. 21: is a schematic sectional view illustrating an electromagnetic wave detector according to a ninth embodiment.
- FIG. 22: is a schematic plan view illustrating an electromagnetic wave detector according to a tenth embodiment.
- FIG. 23: is a schematic sectional view taken along a line XXIII-XXIII in FIG. 22.
- FIG. 24: is a schematic sectional view taken along a line XXIV-XXIV in FIG. 22.
- FIG. 25: is a schematic plan view illustrating a first modification of the electromagnetic wave detector according to the tenth embodiment.
- FIG. 26: is a schematic sectional view taken along a line XXVI-XXVI in FIG. 25.
- FIG. 27: is a schematic plan view illustrating a second modification of the electromagnetic wave detector according to the tenth embodiment.
- FIG. 28: is a schematic sectional view taken along a line XXVIII-XXVIII in FIG. 27.
- FIG. 29: is a schematic sectional view illustrating an electromagnetic wave detector according to an eleventh embodiment.
- FIG. 30: is a schematic sectional view illustrating a modification of the electromagnetic wave detector according to the eleventh embodiment.
- FIG. 31: is a schematic sectional view illustrating an electromagnetic wave detector according to a twelfth embodiment.
- FIG. 32: is a schematic sectional view illustrating a modification of the electromagnetic wave detector according to the twelfth embodiment.
- FIG. 33: is a schematic sectional view illustrating an electromagnetic wave detector according to a fourteenth embodiment.
- FIG. 34: is a schematic sectional view illustrating an electromagnetic wave detector according to a fifteenth embodiment.
- FIG. 35: is a schematic sectional view illustrating an electromagnetic wave detector according to a sixteenth embodiment.
- FIG. 36: is a schematic sectional view illustrating a modification of the electromagnetic wave detector according to the sixteenth embodiment.
- FIG. 37: is a schematic sectional view illustrating an electromagnetic wave detector according to a seventeenth embodiment.
- FIG. 38: is a schematic plan view illustrating an electromagnetic wave detector according to an eighteenth embodiment.
- FIG. 39: is a schematic plan view illustrating a modification of the electromagnetic wave detector according to the eighteenth embodiment.

### DESCRIPTION OF EMBODIMENTS

Hereinafter, embodiments of the present invention will be described. The same components are denoted by the same reference numerals, and a repetitive description will be omitted.

In the embodiments described below, the drawings are schematic and conceptually describe functions or structures. The present invention is not limited to the following embodiments. A basic configuration of an electromagnetic wave detector is common to all the embodiments, unless otherwise specified. In addition, the components denoted by the same reference numerals are the same as or corresponding to them as described above. This is common in the entire specification.

In the embodiments described below, the electromagnetic wave detector will be described using a configuration in the case of detecting visible light or infrared light, but the present invention is not limited thereto. The embodiments described below are also effective as a detector that detects a radio wave such as an X-ray, ultraviolet light, near-infrared light, a terahertz (THz) wave, or a microwave, in addition to the visible light or the infrared light. In the embodiments of the present invention, these light and radio waves are collectively referred to as electromagnetic waves.

In the embodiments of the present invention, the term of p-type graphene or n-type graphene may be used as the graphene. In the following embodiments, the graphene having more holes than the graphene in an intrinsic state is referred to as the p-type graphene, and the graphene having more electrons is referred to as the n-type graphene.

In the embodiments of the present invention, the term of an n-type or p-type may be used for a material of a member in contact with the graphene that is an example of a two-dimensional material layer. Here, for example, the n-type material indicates a material having an electron donating property, and the p-type material indicates a material having an electron withdrawing property. In addition, there is the case where a charge bias is observed in the entire molecule, the case where electrons are dominant is referred to as an n-type, and the case where holes are dominant is referred to as a p-type. Any one of an organic substance and an inorganic substance or a mixture thereof can be used as these materials.

A plasmon resonance phenomenon such as a surface plasmon resonance phenomenon, which is an interaction between a metal surface and light, a phenomenon called pseudo surface plasmon resonance in the sense of resonance applied to the metal surface in a region other than the visible light region and the near-infrared light region, or a phenomenon called metamaterial or plasmonic metamaterial in the sense of manipulating a specific wavelength by a structure having a dimension less than or equal to a wavelength are not particularly distinguished by names, and are treated equally in terms of an effect exerted by the phenomenon. Here, these resonances are referred to as surface plasmon resonance, plasmon resonance, or simply resonance.

In the embodiments described below, the graphene is described as an example of the material of the two-dimensional material layer. However, the material constituting the two-dimensional material layer is not limited to graphene. For example, materials such as transition metal dichalcogenide (TMD), black phosphorus, silicene (two-dimensional honeycomb structure by silicon atoms), and germanene (two-dimensional honeycomb structure by germanium atoms) can be applied as the material of the two-dimensional material layer. Examples of the transition metal dichalcogenide include a transition metal dichalcogenide such as MoS₂, WS₂, and WSe₂.

These materials have a structure similar to that of the graphene, and are materials capable of arraying atoms in a single layer in a two-dimensional plane. Accordingly, even when these materials are applied to the two-dimensional material layer, the same advantageous effect as that when the graphene is applied to the two-dimensional material layer can be obtained.

### First embodiment

### Configuration of electromagnetic wave detector

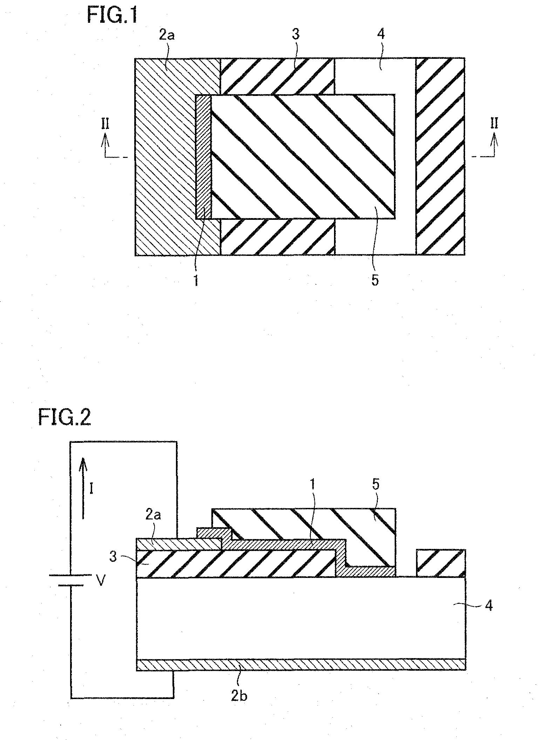

FIG. 1 is a schematic plan view illustrating an electromagnetic wave detector according to a first embodiment. FIG. 2 is a schematic sectional view taken along a line II-II in FIG. 1. The electromagnetic wave detector illustrated in FIGs. 1 and 2 mainly includes a two-dimensional material layer 1, a first electrode 2a, a second electrode 2b, an insulating film 3, a semiconductor layer 4, and a ferroelectric layer 5. Ferroelectric layer 5 has sensitivity to the wavelength of the electromagnetic wave to be detected by the electromagnetic wave detector. When ferroelectric layer 5 is irradiated with the electromagnetic wave having the wavelength to be detected, polarization changes in ferroelectric layer 5. In the electromagnetic wave detector illustrated in FIGS. 1 and 2, two-dimensional material layer 1 and ferroelectric layer 5 are provided such that a resistance value of two-dimensional material layer 1 changes when the polarization changes in ferroelectric layer 5.

Semiconductor layer 4 includes a first surface and a second surface located on a side opposite to the first surface. As illustrated in FIGS. 1 and 2, two-dimensional material layer 1, first electrode 2a, insulating film 3, and ferroelectric layer 5 are disposed on the first surface of semiconductor layer 4. Second electrode 2b is disposed on the second surface of semiconductor layer 4. Hereinafter, on the first surface, a portion located on the side opposite to semiconductor layer 4 with respect to each of two-dimensional material layer 1, first electrode 2a, insulating film 3, and ferroelectric layer 5 is referred to as an upper portion, and a portion located on the side of semiconductor layer 4 with respect to each of two-dimensional material layer 1, first electrode 2a, insulating film 3, and ferroelectric layer 5 is referred to as a lower portion.

For example, semiconductor layer 4 is made of a semiconductor material such as silicon (Si). Specifically, a silicon substrate doped with impurities or the like is used as semiconductor layer 4.

At this point, semiconductor layer 4 may have a multilayer structure, and a pn junction photodiode, a pin photodiode, a Schottky photodiode, or an avalanche photodiode may be used. A phototransistor may be used as semiconductor layer 4.

Although the silicon substrate has been described as an example of the semiconductor material constituting semiconductor layer 4 as described above, other materials may be used as the material constituting semiconductor layer 4. For example, a simple substance of a material such as a compound semiconductor such as germanium (Ge), a group III-V or a group II-V semiconductor, mercury cadmium tellurium (HgCdTe), indium antimony (InSb), lead selenium (PbSe), lead sulfur (PbS), cadmium sulfur (CdS), gallium nitride (GaN), silicon carbide (SiC), gallium phosphide (GaP), indium gallium arsenide (InGaAs), indium arsenide (InAs), a substrate containing a quantum well or a quantum dot, or a Type II superlattice, or a combination thereof may be used as a material constituting semiconductor layer 4.

In the electromagnetic wave detector according to the first embodiment, semiconductor layer 4 and semiconductor layer 4 are preferably doped with impurities such that the electric resistivity of semiconductor layer 4 and semiconductor layer 4 becomes less than or equal to 100 Ω·cm. By doping semiconductor layer 4 and semiconductor layer 4 with a high concentration, the moving speed (reading speed) of the carrier in semiconductor layer 4 and semiconductor layer 4 is increased. As a result, the response speed of the electromagnetic wave detector is improved.

A thickness T1 of semiconductor layer 4 is preferably less than or equal to 10 µm. Carrier deactivation is reduced by reducing thickness T1 of semiconductor layer 4.

As illustrated in FIG. 2, a power supply circuit applying a bias voltage V is electrically connected between first electrode 2a and second electrode 2b. The power supply circuit is a circuit applying voltage V to two-dimensional material layer 1. An ammeter (not illustrated) for detecting current I in two-dimensional material layer 1 is connected to the power supply circuit.

Insulating film 3 is disposed on the first surface of semiconductor layer 4. Insulating film 3 includes a lower surface in contact with the first surface of semiconductor layer 4 and an upper surface located on the side opposite to the lower surface. An opening is formed in insulating film 3 in order to expose a part of the first surface of semiconductor layer 4. The opening extends from the upper surface to the lower surface. At least a part of the upper surface of insulating film 3 is in contact with the lower surface of two-dimensional material layer 1. In other words, insulating film 3 is disposed below two-dimensional material layer 1.

For example, an insulating film made of silicon oxide can be used as insulating film 3. The material constituting insulating film 3 is not limited to the silicon oxide described above, but other insulating materials may be used. For example, tetraethyl orthosilicate, silicon nitride, hafnium oxide, aluminum oxide, nickel oxide, boron nitride, a siloxane-based polymer material, or the like may be used as the material constituting insulating film 3. For example, because boron nitride has an atomic arrangement similar to that of graphene, boron nitride does not adversely affect the mobility of charges even when boron nitride comes into contact with two-dimensional material layer 1 made of the graphene. For this reason, boron nitride is suitable as a material constituting insulating film 3 from the viewpoint of preventing insulating film 3 from inhibiting the performance of two-dimensional material layer 1 such as electron mobility.

In addition, a thickness T2 of insulating film 3, namely, a distance between the lower surface and the upper surface of insulating film 3 is not particularly limited as long as first electrode 2a is insulated from semiconductor layer 4 and no tunnel current is generated. Furthermore, insulating film 3 may not be disposed below two-dimensional material layer 1.

First electrode 2a is disposed on the upper surface of insulating film 3. First electrode 2a is disposed at a position away from the opening of insulating film 3. First electrode 2a includes a lower surface in contact with the upper surface of insulating film 3, an upper surface located on the side opposite to the lower surface, and a side surface extending in a direction intersecting with the upper surface. Second electrode 2b is disposed on the second surface of semiconductor layer 4. As the material constituting the first electrode 2a and the second electrode 2b, any material can be used as long as it is a conductor. For example, a metal material such as gold (Au), silver (Ag), copper (Cu), aluminum (Al), nickel (Ni), chromium (Cr), or palladium (Pd) can be used as the material. An adhesion layer (not illustrated) may be formed between first electrode 2a and insulating film 3 or between second electrode 2b and semiconductor layer 4. The adhesion layer enhances adhesion between first electrode 2a and insulating film 3 or adhesion between second electrode 2b and semiconductor layer 4. As the material constituting the adhesion layer, any material can be used, and for example, a metal material such as chromium (Cr) or titanium (Ti) may be used.

Although first electrode 2a is formed below two-dimensional material layer 1 in FIG. 2, first electrode 2a may be formed above two-dimensional material layer 1. Although second electrode 2b is provided on the entire second surface of semiconductor layer 4 in FIG. 2, second electrode 2b may be in contact with at least a part of semiconductor layer 4. For example, second electrode 2b may be provided so as to be in contact with a part of the first surface, the second surface, and the side surface extending in the direction intersecting the first surface of semiconductor layer 4. Such an electromagnetic wave detector can detect the electromagnetic wave incident from the second surface side. As illustrated in FIG. 2, the electromagnetic wave detector in which second electrode 2b is provided on the entire surface of the second surface is suitable when the electromagnetic wave to be detected is incident only from the first surface side. In the electromagnetic wave detector of FIG. 2, because the electromagnetic wave that is incident from the first surface side and transmitted through ferroelectric layer 5 and semiconductor layer 4 is reflected by second electrode 2b and reaches ferroelectric layer 5 again, the absorptivity of the electromagnetic wave in ferroelectric layer 5 is enhanced.

Two-dimensional material layer 1 is disposed on first electrode 2a, insulating film 3, and semiconductor layer 4. Two-dimensional material layer 1 extends from the inside of the opening of insulating film 3 to first electrode 2a. A part of two-dimensional material layer 1 is disposed on first electrode 2a and is in contact with first electrode 2a. The other part of two-dimensional material layer 1 is disposed inside the opening of insulating film 3 and is in contact with semiconductor layer 4. Two-dimensional material layer 1 is disposed below ferroelectric layer 5 and is in contact with ferroelectric layer 5. Two-dimensional material layer 1 is disposed between first electrode 2a, insulating film 3, and semiconductor layer 4 and ferroelectric layer 5.

Specifically, two-dimensional material layer 1 includes a first portion electrically connected to semiconductor layer 4, a second portion electrically connected to first electrode 2a, and a third portion electrically connecting the first portion to the second portion.

The first portion is disposed on the first surface of semiconductor layer 4 in the opening of insulating film 3. The first portion is disposed below ferroelectric layer 5. The first portion is disposed between semiconductor layer 4 and ferroelectric layer 5 and is in contact with each of semiconductor layer 4 and ferroelectric layer 5. Preferably, the first portion forms a Schottky junction with semiconductor layer 4.

The second portion is disposed on the upper surface of insulating film 3. A part of the second portion is disposed on the upper surface of first electrode 2a. At least a part of the second portion is disposed below ferroelectric layer 5. The second portion is disposed between first electrode 2a and ferroelectric layer 5, and is in contact with each of first electrode 2a and ferroelectric layer 5.

The third portion is disposed on the upper surface of insulating film 3 and the inner peripheral surface of the opening of insulating film 3. The third portion is disposed between insulating film 3 and ferroelectric layer 5 and is in contact with each of insulating film 3 and ferroelectric layer 5. In other words, insulating film 3 separates the third portion of two-dimensional material layer 1 from semiconductor layer 4.

For example, the thicknesses of the first portion, the second portion, and the third portion of two-dimensional material layer 1 are equal to each other. Irregularities caused by the first portion, the second portion, and the third portion are formed on the upper surface of two-dimensional material layer 1. The distance between the upper surface of the first portion and the first surface of semiconductor layer 4 is less than the distance between the upper surface of the second portion and the first surface of semiconductor layer 4.

Two-dimensional material layer 1 includes a region in contact with ferroelectric layer 5 and a region in contact with semiconductor layer 4. Ferroelectric layer 5 is provided such that an electric field in a direction perpendicular to the extending direction of two-dimensional material layer 1 is generated in at least one of a region in contact with ferroelectric layer 5 of two-dimensional material layer 1 and a region in contact with semiconductor layer 4.

Two-dimensional material layer 1 in FIG. 2 extends from the side of first electrode 2a (left side in FIG. 2) to the opposite side (right side in FIG. 2) with respect to the center of the opening of insulating film 3, but is not limited thereto. In FIG. 2, the end (right end) of two-dimensional material layer 1 located on the opposite side of first electrode 2a may be disposed on the left side with respect to the center of the opening of insulating film 3. In addition, two-dimensional material layer 1 in FIG. 2 is disposed so as to expose a part of the first surface of semiconductor layer 4 at the opening of insulating film 3, but the present invention is not limited thereto. Two-dimensional material layer 1 may be disposed so as to cover the entire first surface of semiconductor layer 4 at the opening of insulating film 3. The end (right end) of two-dimensional material layer 1 located on the side opposite to first electrode 2a may be disposed on insulating film 3 located on the side opposite to first electrode 2a with respect to the opening.

For example, single-layer graphene can be used as two-dimensional material layer 1. The single-layer graphene is a monatomic layer of a two-dimensional carbon crystal. The single-layer graphene has carbon atoms in each chain arranged in a hexagonal shape. Two-dimensional material layer 1 may be configured as multilayer graphene in which at least two layers of single-layer graphene are laminated. Non-doped graphene or graphene doped with p-type or n-type impurities may be used as two-dimensional material layer 1.

When the multilayered graphene is used for two-dimensional material layer 1, photoelectric conversion efficiency of two-dimensional material layer 1 increases, and the sensitivity of the electromagnetic wave detector increases. In the multilayered graphene used as two-dimensional material layer 1, the direction of a lattice vector of a hexagonal lattice in arbitrary two layers of graphene may not coincide or may coincide. For example, a band gap is formed in two-dimensional material layer 1 by laminating at least two layers of graphene. As a result, a wavelength selection effect of the electromagnetic wave to be photoelectrically converted can be provided. When the number of layers in the multilayered graphene constituting two-dimensional material layer 1 increases, the mobility of the carrier in the channel region decreases. On the other hand, in this case, two-dimensional material layer 1 is less likely to be affected by carrier scattering from an underlying structure such as a substrate, and as a result, a noise level decreases. Therefore, in the electromagnetic wave detector using the multilayered graphene as two-dimensional material layer 1, the light absorption increases, and the detection sensitivity of the electromagnetic wave can be enhanced.

When two-dimensional material layer 1 is in contact with first electrode 2a, the carrier is doped from first electrode 2a to two-dimensional material layer 1. For example, when gold (Au) is used as the material of first electrode 2a, a hole is doped in two-dimensional material layer 1 near first electrode 2a due to a difference in work function between two-dimensional material layer 1 and Au. When the electromagnetic wave detector is driven in the electron conduction state in this state, the mobility of the electron flowing in the channel region of two-dimensional material layer 1 decreases due to the influence of the hole doped in two-dimensional material layer 1 from first electrode 2a, and the contact resistance between two-dimensional material layer 1 and first electrode 2a increases. Due to the increase in the contact resistance, the mobility of the electron (carrier) due to the electric field effect in the electromagnetic wave detector decreases, and the performance of the electromagnetic wave detector may decrease. In particular, when the single-layer graphene is used as two-dimensional material layer 1, the doping amount of the carrier injected from first electrode 2a is large. For this reason, the decrease in the electron mobility in the electromagnetic wave detector is particularly remarkable when the single-layer graphene is used as two-dimensional material layer 1. Accordingly, when all two-dimensional material layers 1 are formed of the single-layer graphene, the performance of the electromagnetic wave detector may be degraded.

Therefore, the first portion of two-dimensional material layer 1 that is easily doped with the carrier from first electrode 2a may be made of multilayer graphene. The multilayer graphene has smaller carrier doping from first electrode 2a than the single layer graphene. Therefore, an increase in contact resistance between two-dimensional material layer 1 and first electrode 2a can be prevented. As a result, the above-described decrease in electron mobility in the electromagnetic wave detector can be prevented and the performance of the electromagnetic wave detector can be improved.

Nanoribbon shaped graphene (hereinafter, also referred to as graphene nanoribbons) can also be used as two-dimensional material layer 1. In this case, for example, any of a graphene nanoribbon simple substance, a composite obtained by laminating a plurality of graphene nanoribbons, or a structure in which graphene nanoribbons are periodically arranged on a plane can be used as two-dimensional material layer 1. For example, when a structure in which graphene nanoribbons are periodically arranged is used as two-dimensional material layer 1, the plasmon resonance can be generated in the graphene nanoribbons. As a result, the sensitivity of the electromagnetic wave detector can be improved. At this point, the structure in which the graphene nanoribbons are periodically arranged is sometimes referred to as graphene metamaterial. Accordingly, the above-described effect can also be obtained in the electromagnetic wave detector using the graphene metamaterial as two-dimensional material layer 1.

Ferroelectric layer 5 is disposed on two-dimensional material layer 1. That is, ferroelectric layer 5 is disposed on the side opposite to semiconductor layer 4 with respect to two-dimensional material layer 1. Ferroelectric layer 5 is in contact with two-dimensional material layer 1. Ferroelectric layer 5 is disposed on each of the first portion, the second portion, and the third portion of two-dimensional material layer 1, and is in contact with each of the first portion, the second portion, and the third portion of two-dimensional material layer 1.

Specifically, ferroelectric layer 5 includes a fourth portion disposed on the first portion of two-dimensional material layer 1 and in contact with the first portion, a fifth portion disposed on the second portion of two-dimensional material layer 1 and in contact with the second portion, and a sixth portion disposed on the third portion of two-dimensional material layer 1 and in contact with the third portion.

For example, the thickness of each of the fourth portion, the fifth portion, and the sixth portion of ferroelectric layer 5 is equal to each other. Irregularities caused by the first portion, the second portion, and the third portion are formed on the upper surface of two-dimensional material layer 1. The distance between the upper surface of the first portion and the first surface of semiconductor layer 4 is less than the distance between the upper surface of the second portion and the first surface of semiconductor layer 4.

As the material constituting ferroelectric layer 5, any material can be used as long as the material generates polarization with respect to the detection wavelength. For example, the material constituting the ferroelectric layer 5 includes at least one of BaTiO₃ (barium titanate), LiNbO₃ (lithium niobate), LiTaO₃ (lithium tantalate), SrTiO₃ (strontium titanate), PZT (lead zirconate titanate), SBT (strontium bismuth tantalate), BFO (bismuth ferrite), ZnO (zinc oxide), HfO₂ (hafnium oxide), and polyvinylidene fluoride-based ferroelectric (PVDF, P (VDF-TrFE), P (VDF-TrFE-CTFE), and the like) that is an organic polymer. Ferroelectric layer 5 may be formed by further laminating and mixing different ferroelectric materials.

The material constituting ferroelectric layer 5 is not limited to the ferroelectric material, but may be any pyroelectric element that exhibits a pyroelectric effect. Specifically, the material constituting ferroelectric layer 5 may be any ferroelectric in which a polarization change is generated in response to a change in thermal energy. Because the electromagnetic wave simply acts as a heat source in the pyroelectric effect, the pyroelectric effect basically has no wavelength dependency. Accordingly, ferroelectric layer 5 has the sensitivity to wide-band electromagnetic waves.

Preferably, ferroelectric layer 5 is designed such that the change rate of the dielectric polarization in ferroelectric layer 5 is as short as possible. Specifically, the thickness of ferroelectric layer 5 is preferably thin within a range in which a polarization change can be imparted to two-dimensional material layer 1.

The electromagnetic wave detector may further include a Mott insulator that is in contact with ferroelectric layer 5 and in which a light-induced phase transition is generated by the light irradiation to change a physical property (for example, temperature).

Ferroelectric layer 5 is disposed so as to overlap with at least one of the first portion, the second portion, and the third portion of two-dimensional material layer 1, and may be provided such that a resistance value of two-dimensional material layer 1 changes when the polarization in ferroelectric layer 5 changes.

In addition, the film thickness of ferroelectric layer 5 is preferably the thickness at which the electric field as large as possible is applied to graphene layer 1 when graphene layer 1 is irradiated with the electromagnetic wave. The polarization direction of ferroelectric layer 5 is not particularly limited, but is preferably the direction perpendicular to the planar direction of the two-dimensional material layer.

A protective film (not illustrated) may be formed on two-dimensional material layer 1. The protective film may be provided so as to cover the periphery of two-dimensional material layer 1, semiconductor layer 4, first electrode 2a, and ferroelectric layer 5. Any material can be used as the material constituting the protective film, and for example, an insulating film made of silicon oxide can be used as the protective film. An insulator such as an oxide or a nitride, for example, silicon oxide, silicon nitride, hafnium oxide, aluminum oxide, boron nitride, or the like may be used as a material constituting the protective film.

The electromagnetic wave detector of the first embodiment has the above-described configuration.

### Method for manufacturing electromagnetic wave detector

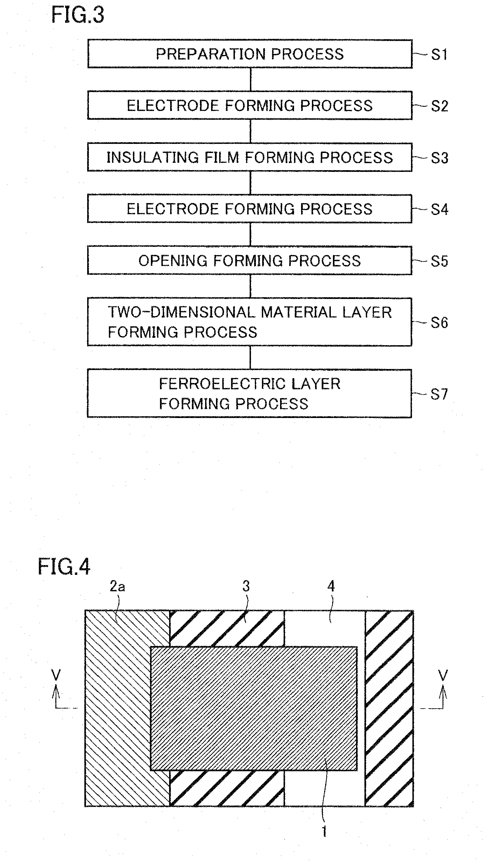

FIG. 3 is a flowchart illustrating a method for manufacturing the electromagnetic wave detector according to the first embodiment. With reference to FIG. 3, the method for manufacturing the electromagnetic wave detector illustrated in FIGS. 1 and 2 will be described.

First, a preparation process (S 1) illustrated in FIG. 3 is performed. In this process (S1), semiconductor layer 4 that is a flat substrate made of, for example, silicon is prepared.

Subsequently, an electrode forming process (S2) is performed. In this process (S2), second electrode 2b is formed on the back surface of semiconductor layer 4. Specifically, first, a protective film is formed on the surface of semiconductor layer 4. For example, a resist is used as the protective film. In this state, second electrode 2b is formed on the back surface of semiconductor layer 4. For example, a metal such as gold (Au), silver (Ag), copper (Cu), aluminum (Al), nickel (Ni), or chromium (Cr) can be used as a material constituting second electrode 2b. At this time, in order to improve the adhesion between semiconductor layer 4 and second electrode 2b, the adhesion layer may be formed on the back surface of semiconductor layer 4 prior to second electrode 2b. For example, copper (Cr) or titanium (Ti) can be used as the material of the adhesion layer. The process (S2) may be performed after the processes (S3 to S7) as long as the surface of semiconductor layer 4 is protected.

Subsequently, an insulating film forming process (S3) is performed. In this process (S3), insulating film 3 is formed on the surface of semiconductor layer 4. For example, when semiconductor layer 4 is silicon, insulating film 3 may be silicon oxide (SiO₂) formed by partially thermally oxidizing the surface of semiconductor layer 4. Alternatively, the insulating layer may be formed on the surface of semiconductor layer 4 by a chemical vapor deposition (CVD) method or a sputtering method.

Subsequently, an electrode forming process (S4) is performed. In this process (S4), first electrode 2a is formed on insulating film 3. For example, a metal such as gold (Au), silver (Ag), copper (Cu), aluminum (Al), nickel (Ni), or chromium (Cr) is used as a material constituting first electrode 2a. At this time, in order to improve adhesion between first electrode 2a and insulating film 3, the adhesion layer may be formed between insulating film 3 and first electrode 2a. For example, chromium (Cr), titanium (Ti), or the like can be used as the material constituting the adhesion layer.

For example, the following process can be used as a method for forming first electrode 2a. First, a resist mask is formed on the surface of insulating film 3 by photolithography, EB drawing, or the like. In the resist mask, an opening is formed in a region where first electrode 2a is to be formed. Thereafter, a film of metal or the like to be first electrode 2a is formed on the resist mask. The film can be formed by a vapor deposition method, a sputtering method, or the like. At this time, the film is formed so as to extend from the inside of the opening of the resist mask to the upper surface of the resist mask. Thereafter, by removing the resist mask together with a part of the film, another part of the film arranged in the opening of the resist mask remains on the surface of insulating film 3 to become first electrode 2a. The method described above is generally called lift-off.

Another method may be used as the method for forming first electrode 2a. For example, a film such as a metal film to be first electrode 2a is first formed on the surface of insulating film 3. Thereafter, a resist mask is formed on the film by a photolithography method. The resist mask is formed so as to cover the region where first electrode 2a is to be formed, but is not formed in a region other than the region where first electrode 2a is to be formed. Thereafter, the film is partially removed using the resist mask as a mask by wet etching or dry etching. As a result, a part of the film remains under the resist mask. A part of the film becomes first electrode 2a. Thereafter, the resist mask is removed. In this manner, first electrode 2a may be formed.

Subsequently, an opening forming process (S5) is performed. In this process (S5), an opening is formed in insulating film 3. Specifically, a resist mask is formed on insulating film 3 by photolithography, EB drawing, or the like. In the resist mask, an opening is formed in a region where the opening of insulating film 3 is to be formed. Thereafter, insulating film 3 is partially removed using a resist mask as a mask by wet etching or dry etching to form an opening. Subsequently, the resist mask is removed. The process (S5) may be performed before the process (S4).

Subsequently, a two-dimensional material layer forming process (S6) is performed. In this process (S6), two-dimensional material layer 1 is formed so as to entirely cover first electrode 2a, insulating film 3, and a part of semiconductor layer 4 exposed in the opening of insulating film 3. As the material constituting two-dimensional material layer 1, for example, an atomic layer material such as graphene or a molecular layer material may be used. Two-dimensional material layer 1 may be formed by any method. For example, two-dimensional material layer 1 may be formed by epitaxial growth, or two-dimensional material layer 1 formed in advance using a CVD method may be transferred onto a part of first electrode 2a, insulating film 3, and semiconductor layer 4 and attached thereto. Alternatively, two-dimensional material layer 1 may be formed using screen printing or the like. Further, two-dimensional material layer 1 peeled off by mechanical peeling or the like may be transferred onto first electrode 2a or the like. Subsequently, a resist mask is formed on two-dimensional material layer 1 using photolithography or the like. The resist mask is formed so as to cover a region where two-dimensional material layer 1 remains, but is not formed in a region where two-dimensional material layer 1 does not remain. Thereafter, two-dimensional material layer 1 is partially removed by etching with oxygen plasma using a resist mask as a mask. As a result, unnecessary portions of two-dimensional material layer are removed, and two-dimensional material layer 1 as illustrated in FIGS. 1 and 2 is formed. Thereafter, the resist mask is removed.

Subsequently, a ferroelectric layer forming process (S7) is performed. In this process (S7), ferroelectric layer 5 is formed on two-dimensional material layer 1. For example, BaTiO₃ (barium titanate), LiNbO₃ (lithium niobate), LiTaO₃ (lithium tantalate), SrTiO₃ (strontium titanate), PZT (lead zirconate titanate), SBT (strontium bismuth tantalate), BFO (bismuth ferrite), ZnO (zinc oxide), HfO₂ (hafnium oxide), polyvinylidene fluoride-based ferroelectric as an organic polymer, or the like may be used as a material for forming ferroelectric layer 5. Ferroelectric layer 5 may be formed by any method. For example, when ferroelectric layer 5 is made of a polymer-based material, a polymer film is formed by a spin coating method or the like, and then processed by a photolithography method. In the case of other materials, patterning is performed using a photolithography method after a film is formed by sputtering, vapor deposition, MOD coating, or the like. In addition, a method called lift-off for removing a resist mask after forming a ferroelectric material using the resist mask as a mask may be used.

The electromagnetic wave detector illustrated in FIGS. 1 and 2 is obtained through the above processes (S 1 to S7). In the manufacturing method described above, two-dimensional material layer 1 is formed on first electrode 2a, but two-dimensional material layer 1 may be formed in advance on insulating film 3, and first electrode 2a may be formed so as to overlap with a part of two-dimensional material layer 1. However, in the case of using this structure, it is necessary to pay attention not to cause process damage to two-dimensional material layer 1 at the time of forming first electrode 2a. For example, it is conceivable to form first electrode 2a while a region other than the region formed by overlapping first electrode 2a in two-dimensional material layer 1 is covered in advance with a protective film or the like.

### Operating principle of electromagnetic wave detector

An operation principle of the electromagnetic wave detector of the first embodiment will be described below.

First, as illustrated in FIG. 2, a power supply circuit that applies voltage V is electrically connected between first electrode 2a and second electrode 2b, and first electrode 2a, two-dimensional material layer 1, semiconductor layer 4, and second electrode 2b are electrically connected in this order. Subsequently, voltage V is applied between first electrode 2a and second electrode 2b. Preferably, voltage V is set to be reverse bias with respect to the Schottky junction between two-dimensional material layer 1 and semiconductor layer 4. When voltage V is applied, current I flows through two-dimensional material layer 1 that becomes a part of the current path between first electrode 2a and second electrode 2b. An ammeter (not illustrated) is installed in the power supply circuit, and current I flowing through two-dimensional material layer 1 is monitored by the ammeter.

Subsequently, ferroelectric layer 5 is irradiated with the electromagnetic wave. In this case, the change in dielectric polarization is generated inside ferroelectric layer 5 due to the pyroelectric effect of ferroelectric layer 5. As a result, the change in polarization in ferroelectric layer 5 gives the electric field change to two-dimensional material layer 1. As a result, a gate voltage is applied to two-dimensional material layer 1 in a pseudo manner, and the resistance value in two-dimensional material layer 1 changes. This is called an optical gate effect. Current I that is a photocurrent flowing through two-dimensional material layer 1 changes due to the change in the resistance value in two-dimensional material layer 1. The electromagnetic wave with which the electromagnetic wave detector is irradiated can be detected by detecting the change in current I.

For example, when semiconductor layer 4 constituting semiconductor layer 4 is made of p-type material silicon and when two-dimensional material layer 1 is made of n-type material graphene, two-dimensional material layer 1 and semiconductor layer 4 are joined to form the Schottky junction. At this time, current I can be made zero by adjusting voltage V to apply a reverse bias to the Schottky junction. That is, the electromagnetic wave detector of the first embodiment can perform the OFF operation.

When ferroelectric layer 5 is irradiated with the electromagnetic wave, the dielectric polarization of ferroelectric layer 5 changes due to the pyroelectric effect, the Fermi level of two-dimensional material layer 1 is modulated, and the energy barrier between two-dimensional material layer 1 and semiconductor layer 4 decreases. As a result, the current flows through semiconductor layer 4 only when semiconductor layer 4 is irradiated with the electromagnetic wave to detect current I.

Here, the electromagnetic wave detector of the first embodiment is not limited to the configuration for detecting the change in current in two-dimensional material layer 1 as described above, and for example, a constant current may be caused to flow between first electrode 2a and second electrode 2b, and the change in voltage V between first electrode 2a and second electrode 2b (that is, the change in the voltage value in two-dimensional material layer 1) may be detected.

The electromagnetic wave may be detected using two or more of the same electromagnetic wave detectors. For example, two or more of the same electromagnetic wave detectors are prepared. One electromagnetic wave detector is disposed in a shielded space that is not irradiated with the electromagnetic wave. Another electromagnetic wave detector is disposed in a space irradiated with the electromagnetic wave to be measured. Then, a difference between current I or voltage V of another electromagnetic wave detector irradiated with the electromagnetic wave and current I or voltage V of the electromagnetic wave detector disposed in the shielded space is detected. In this manner, the electromagnetic wave may be detected.

### Operation of electromagnetic wave detector

A specific operation of the electromagnetic wave detector illustrated in FIGS. 1 and 2 will be described below. Here, the case where p-type silicon is used as semiconductor layer 4, graphene is used as two-dimensional material layer 1, and lithium niobate is used as ferroelectric layer 5 will be described.

As illustrated in FIG. 2, when the voltage is applied so as to have a reverse bias with respect to the Schottky junction between two-dimensional material layer 1 and semiconductor layer 4, a depletion layer is formed in the vicinity of the junction interface between two-dimensional material layer 1 and semiconductor layer 4. The range of the detection wavelength of the electromagnetic wave detector is determined according to the absorption wavelength of lithium niobate.

When the electromagnetic wave having the detection wavelength is incident on ferroelectric layer 5, the change in dielectric polarization is generated in ferroelectric layer 5 due to the pyroelectric effect. An electric field change is generated in two-dimensional material layer 1 due to the polarization change in ferroelectric layer 5. This is the optical gate effect described above. As described above, the graphene constituting two-dimensional material layer 1 has the high mobility, and can obtain a large displacement current with respect to a slight electric field change. For this reason, the Fermi level of two-dimensional material layer 1 greatly changes due to the pyroelectric effect of ferroelectric layer 5, and the energy barrier with semiconductor layer 4 decreases. Thus, the charge is injected from first electrode 2a into two-dimensional material layer 1. Furthermore, the photo-injected current charge extracted from semiconductor layer 4 is greatly amplified by the optical gate effect in two-dimensional material layer 1. For this reason, in the electromagnetic wave detector according to the first embodiment, the high sensitivity exceeding the quantum efficiency of 100 % can be attained.

Furthermore, when the change rate of the dielectric polarization of ferroelectric layer 5 is designed to be as short as possible, the time from when the electromagnetic wave is incident on the electromagnetic wave detector until the resistance value changes in two-dimensional material layer 1 is shortened. According to such the electromagnetic wave detector, delay of amplification due to the optical gate effect is eliminated, and the high-speed response can be achieved.

### Advantageous effect

The electromagnetic wave detector of the first embodiment includes semiconductor layer 4, two-dimensional material layer 1 electrically connected to semiconductor layer 4, first electrode 2a electrically connected to two-dimensional material layer 1 without semiconductor layer 4 interposed therebetween, second electrode 2b electrically connected to two-dimensional material layer 1 with semiconductor layer 4 interposed between, and ferroelectric layer 5 that is in contact with at least a part of two-dimensional material layer 1.

In the electromagnetic wave detector, the resistance value of two-dimensional material layer 1 may change when the polarization in ferroelectric layer 5 changes due to the pyroelectric effect. As a result, the conductivity of two-dimensional material layer 1 is modulated by the optical gate effect, and as a result, the photocurrent can be amplified in two-dimensional material layer 1.

The current change amount in two-dimensional material layer 1 due to the change in polarization in ferroelectric layer 5 is larger than the current change amount in the normal semiconductor. In particular, in two-dimensional material layer 1, the large current change is generated with respect to the slight potential change as compared with the normal semiconductor. For example, when the single-layer graphene is used as two-dimensional material layer 1, the thickness of two-dimensional material layer 1 is equivalent to one atomic layer, which is extremely thin. In addition, the electron mobility in the single-layer graphene is large. In this case, the current change amount in two-dimensional material layer 1 calculated from the electron mobility, the thickness, and the like in two-dimensional material layer 1 is about several hundred times to several thousand times the current change amount in the normal semiconductor.

Accordingly, the extraction efficiency of the detection current in two-dimensional material layer 1 is greatly improved by utilizing the optical gate effect. Such optical gate effect does not directly enhance the quantum efficiency of the photoelectric conversion material such as the normal semiconductor, but increases the current change due to the incidence of the electromagnetic wave. For this reason, the quantum efficiency of the electromagnetic wave detector equivalently calculated from the differential current due to the incidence of the electromagnetic wave can exceed 100 %. Accordingly, the detection sensitivity of the electromagnetic wave by the electromagnetic wave detector according to the first embodiment is higher than that of the conventional semiconductor electromagnetic wave detector or the graphene electromagnetic wave detector to which the optical gate effect is not applied.

In addition, the electromagnetic wave detector according to the first embodiment further includes insulating film 3 that is in contact with a part of semiconductor layer 4 and has the opening that opens another part of semiconductor layer 4. Two-dimensional material layer 1 is electrically connected to another part of semiconductor layer 4 at the opening, and specifically, forms the Schottky junction with semiconductor layer 4. Because two-dimensional material layer 1 and semiconductor layer 4 are joined to form the Schottky junction, the current foes not flow when the reverse bias is applied, and the electromagnetic wave detector can perform the OFF operation.

In the electromagnetic wave detector according to the first embodiment, two-dimensional material layer 1 has the region disposed on insulating film 3, so that the conductivity of two-dimensional material layer 1 due to the optical gate effect is easily modulated to be larger than that in the case where two-dimensional material layer 1 does not have the region disposed on insulating film 3.

In addition, the amount of change in the current value I when the electromagnetic wave detector according to the first embodiment is irradiated with the electromagnetic wave includes the amount of photocurrent generated by photoelectric conversion in two-dimensional material layer 1 in addition to the change amount of the current generated by the resistance change of two-dimensional material layer 1 due to the dielectric polarization generated in ferroelectric layer 5 and the change amount of the current generated by the energy barrier change between two-dimensional material layer 1 and semiconductor layer 4. That is, in the electromagnetic wave detector according to the first embodiment, the photocurrent due to the photoelectric conversion efficiency inherent in two-dimensional material layer 1 can also be detected in addition to the current generated by the optical gate effect and the current accompanying the change in the energy barrier due to the incidence of the electromagnetic wave.

As described above, the electromagnetic wave detector according to the first embodiment can achieve both the favorable sensitivity with the quantum efficiency of greater than or equal to 100 % and the OFF operation.

In the electromagnetic wave detector according to the first embodiment, when silicon is used for semiconductor layer 4, the readout circuit can be formed in semiconductor layer 4. Thus, the signal can be read without forming the circuit outside the element.

### Second embodiment

### Configuration of electromagnetic wave detector

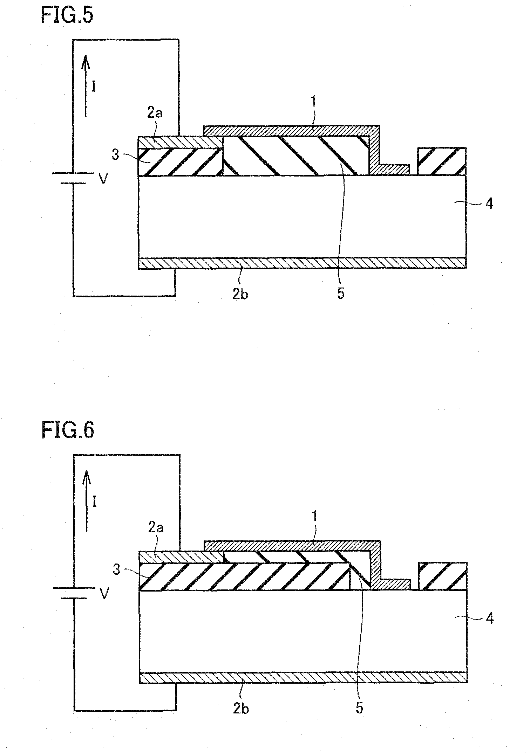

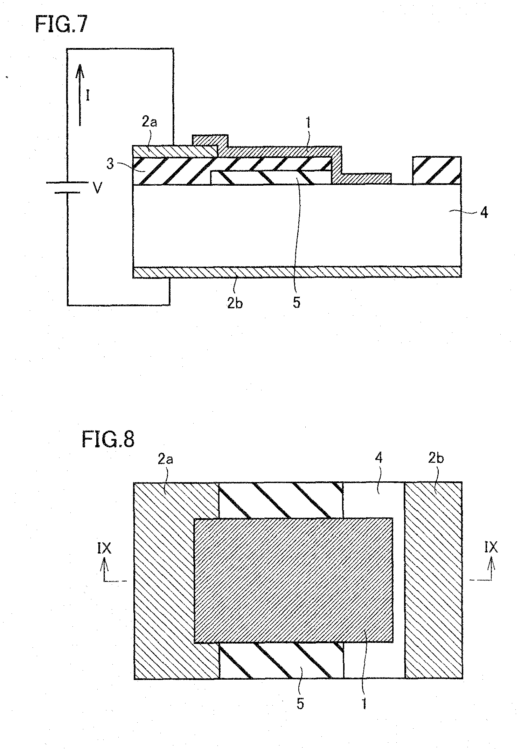

FIG. 4 is a schematic plan view illustrating an electromagnetic wave detector according to a second embodiment. FIG. 5 is a schematic sectional view taken along a line V-V in FIG. 4. FIG. 6 is a schematic sectional view illustrating a first modification of the electromagnetic wave detector according to the second embodiment. FIG. 7 is a schematic sectional view illustrating a second modification of the electromagnetic wave detector according to the second embodiment. FIGS. 5 to 7 all correspond to FIG. 4.

The electromagnetic wave detector illustrated in FIG. 4 basically has the same configuration as the electromagnetic wave detector illustrated in FIGS. 1 and 2 and can obtain the same effect, but the disposition of ferroelectric layers 5 is different from that of the electromagnetic wave detector illustrated in FIGS. 1 and 2. That is, in the electromagnetic wave detector of FIG. 4, ferroelectric layer 5 is disposed below two-dimensional material layer 1 or insulating film 3. In FIG. 5, ferroelectric layer 5 is formed below two-dimensional material layer 1 and above semiconductor layer 4.

The first modification of the electromagnetic wave detector according to the second embodiment shown in FIG. 6 basically has the same configuration as the electromagnetic wave detector illustrated in FIG. 5, but the disposition of ferroelectric layers 5 is different from that of the electromagnetic wave detector illustrated in FIG. 5. That is, in the electromagnetic wave detector of FIG. 6, ferroelectric layer 5 is formed below two-dimensional material layer 1 and above insulating film 3 and semiconductor layer 4.

The second modification of the electromagnetic wave detector according to the second embodiment shown in FIG. 7 basically has the same configuration as the electromagnetic wave detector illustrated in FIG. 5, but the disposition of ferroelectric layers 5 is different from that of the electromagnetic wave detector illustrated in FIG. 5. That is, in the electromagnetic wave detector of FIG. 7, ferroelectric layer 5 is formed below insulating film 3 and above semiconductor layer 4. Below insulating film 3, ferroelectric layer 5 is in contact with two-dimensional material layer 1. At this point, the polarization change may be generated in ferroelectric layer 5 in the horizontal direction with respect to the bonding interface between two-dimensional material layer 1 and semiconductor layer 4. In that case, the energy barrier between two-dimensional material layer 1 and semiconductor layer 4 can be changed by electromagnetic wave irradiation. In addition, the polarization change may be generated perpendicularly to the bonding interface between insulating film 3 and two-dimensional material layer 1. In this case, the conductivity of two-dimensional material layer 1 changes, and the optical gate effect can be generated. In addition, the polarization change may be caused in each direction. At this time, when ferroelectric layer 5 and two-dimensional material layer 1 are not in contact with each other, the same effect as that of a fifth embodiment is obtained.

### Advantageous effect

In the electromagnetic wave detector, ferroelectric layer 5 is disposed below two-dimensional material layer 1 or below insulating film 3.

In this case, by disposing ferroelectric layer 5 under two-dimensional material layer 1 or under insulating film 3, two-dimensional material layer 1 can eliminate process damage in film formation of ferroelectric layer 5, and degradation in performance of two-dimensional material layer 1 can be prevented, so that the sensitivity of the electromagnetic wave detector can be increased.

At this point, the configuration of the electromagnetic wave detector according to the second embodiment can also be applied to another embodiment.

### Third embodiment

### Configuration of electromagnetic wave detector

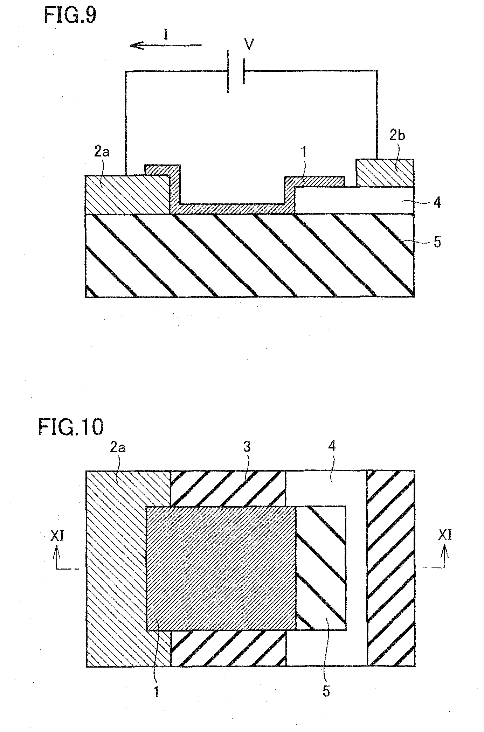

FIG. 8 is a schematic plan view illustrating an electromagnetic wave detector according to a third embodiment. FIG. 9 is a schematic sectional view taken along line IX-IX in FIG. 8.

The electromagnetic wave detector illustrated in FIG. 8 basically has the same configuration as the electromagnetic wave detector illustrated in FIGS. 1 and 2 and can obtain the same effect, but is different from the electromagnetic wave detector illustrated in FIGS. 1 and 2 in that two-dimensional material layer 1, first electrode 2a, second electrode 2b, and semiconductor layer 4 are disposed on ferroelectric layer 5. That is, semiconductor layer 4 and first electrode 2a are provided on a part of ferroelectric layer 5, second electrode 2b is provided on semiconductor layer 4, and two-dimensional material layer 1 extends from first electrode 2a to semiconductor layer 4 through ferroelectric layer 5.

### Advantageous effect

In the electromagnetic wave detector, each layer is formed on ferroelectric layer 5. Accordingly, ferroelectric layer 5 can be configured as a ferroelectric crystal substrate. Such ferroelectric layer 5 can have higher crystallinity and can be thicker than ferroelectric layer 5 that is not configured as the ferroelectric crystal substrate. Because the change rate of the polarization caused by electromagnetic wave irradiation in such ferroelectric layer 5 is higher than that in ferroelectric layer 5 that is not configured as the ferroelectric crystal substrate, the sensitivity of the electromagnetic wave detector is increased. In the electromagnetic wave detector of the first embodiment, when ferroelectric layer 5 is formed on two-dimensional material layer 1, two-dimensional material layer 1 may be subjected to the process damage. On the other hand, in the electromagnetic wave detector of the third embodiment, because two-dimensional material layer 1 is not subjected to the process damage, the performance degradation of two-dimensional material layer 1 can be prevented, and thus, the sensitivity of the electromagnetic wave detector can be increased.

At this point, the configuration of the electromagnetic wave detector according to the second embodiment can also be applied to another embodiment.

### Fourth embodiment

### Configuration of electromagnetic wave detector

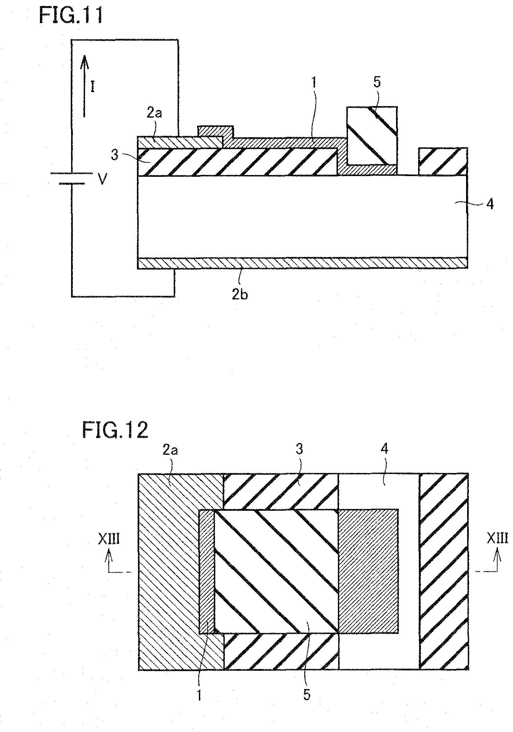

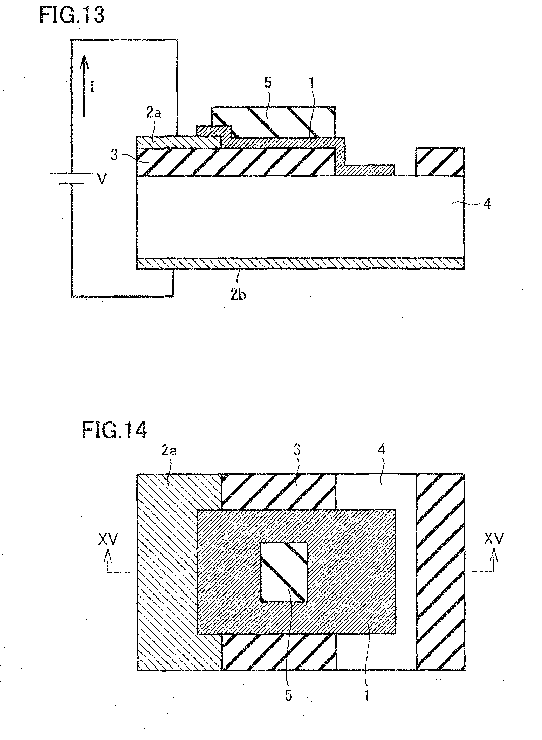

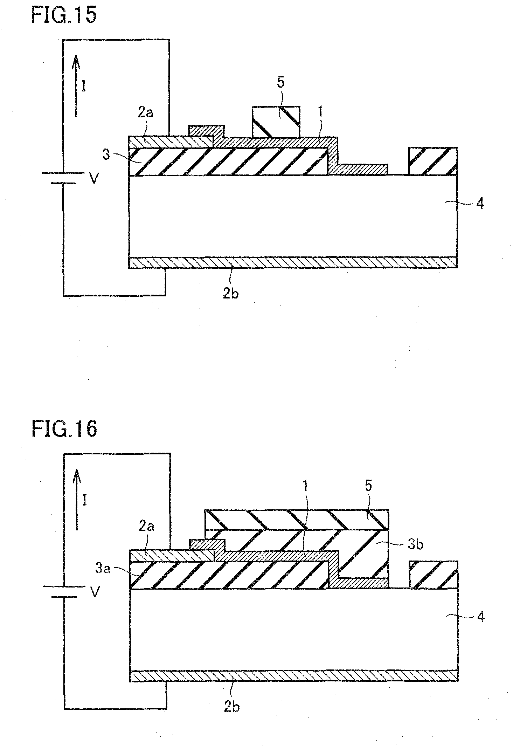

FIG. 10 is a schematic plan view illustrating an electromagnetic wave detector according to a fourth embodiment. FIG. 11 is a schematic sectional view taken along a line XI-XI in FIG. 10. FIG. 12 is a schematic plan view illustrating a first modification of the electromagnetic wave detector according to the fourth embodiment. FIG. 13 is a schematic sectional view taken along a line XIII-XIII in FIG. 12. FIG. 14 is a schematic plan view illustrating a second modification of the electromagnetic wave detector according to the fourth embodiment. FIG. 15 is a schematic sectional view taken along a line XV-XV in FIG. 14.

The electromagnetic wave detector illustrated in FIG. 10 basically has the same configuration as the electromagnetic wave detector illustrated in FIGS. 1 and 2 and can obtain the same effect, but the disposition of ferroelectric layers 5 is different from that of the electromagnetic wave detector illustrated in FIGS. 1 and 2. That is, in the electromagnetic wave detector of FIG. 10, ferroelectric layer 5 is disposed only on the bonding surface between two-dimensional material layer 1 and semiconductor layer 4. In other words, ferroelectric layer 5 is disposed so as to overlap only the first portion of two-dimensional material layer 1 and is in contact with only the first portion.

In the first modification of the electromagnetic wave detector of the fourth embodiment in FIG. 12, ferroelectric layer 5 is disposed only on two-dimensional material layer 1 on insulating film 3. In other words, ferroelectric layer 5 is disposed so as to overlap only the second portion and the third portion of two-dimensional material layer 1, and is in contact with only the second portion and the third portion.

In the second modification of the electromagnetic wave detector according to the fourth embodiment shown in FIG. 14, ferroelectric layer 5 is disposed in a part of two-dimensional material layer 1. In other words, ferroelectric layer 5 is disposed so as to overlap only the third portion of two-dimensional material layer 1 and is in contact with only the third portion.

### Advantageous effect

In the electromagnetic wave detector, ferroelectric layer 5 is disposed on the bonding surface between two-dimensional material layer 1 and semiconductor layer 4. In this case, when the electromagnetic wave is incident on ferroelectric layer 5, the energy barrier between two-dimensional material layer 1 and semiconductor layer 4 can be changed by the polarization change of ferroelectric layer 5, and the sensitivity of the electromagnetic wave detector can be increased.

In the first modification of the electromagnetic wave detector, ferroelectric layer 5 is disposed on two-dimensional material layer 1 on insulating film 3. In this case, when the electromagnetic wave is incident on ferroelectric layer 5, the conductivity of two-dimensional material layer 1 is modulated by the polarization change of ferroelectric layer 5, and the sensitivity of the electromagnetic wave detector can be increased.

In the second modification of the electromagnetic wave detector, ferroelectric layer 5 is disposed in a part of two-dimensional material layer 1. In this case, when the electromagnetic wave is incident on ferroelectric layer 5, the conductivity is modulated near the region in contact with ferroelectric layer 5. As a result, the conductivity can be modulated in an arbitrary region of two-dimensional material layer 1.

At this point, the configuration of the electromagnetic wave detector according to the second embodiment can also be applied to another embodiment.

### Fifth embodiment

### Configuration of electromagnetic wave detector

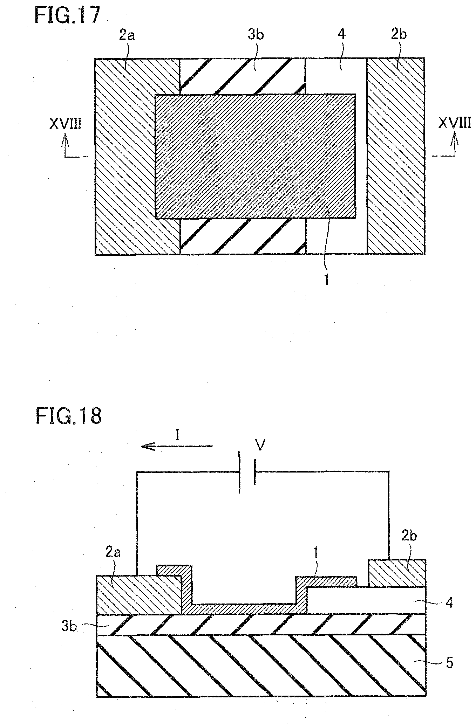

FIG. 16 is a schematic sectional view illustrating an electromagnetic wave detector according to a fifth embodiment. FIG. 16 corresponds to FIG. 1. FIG. 17 is a schematic plan view illustrating a first modification of the electromagnetic wave detector according to the fifth embodiment. FIG. 18 is a schematic sectional view taken along a line XVIII-XVIII in FIG. 17.

The electromagnetic wave detector illustrated in FIG. 16 basically has the same configuration as the electromagnetic wave detector illustrated in FIGS. 1 and 2 and can obtain the same effect, but is different from the electromagnetic wave detector illustrated in FIGS. 1 and 2 in that the electromagnetic wave detector illustrated in FIG. 16 includes an insulating film 3b separating ferroelectric layer 5 and two-dimensional material layer 1. Ferroelectric layer 5 is not in direct contact with two-dimensional material layer 1.

The electromagnetic wave detector illustrated in FIGS. 17 and 18 basically has the same configuration as the electromagnetic wave detector illustrated in FIGS. 8 and 9 and can obtain the same effect, but is different from the electromagnetic wave detector illustrated in FIGS. 8 and 9 in that he electromagnetic wave detector illustrated in FIGS. 17 and 18 includes the insulating film 3b separating the ferroelectric layer 5 and the two-dimensional material layer 1. In other words, the electromagnetic wave detector illustrated in FIGS. 17 and 18 basically has the same configuration as the electromagnetic wave detector illustrated in FIG. 16 and can obtain the same effect, but is different from the electromagnetic wave detector illustrated in FIG. 16 in that two-dimensional material layer 1, first electrode 2a, second electrode 2b, semiconductor layer 4, and insulating film 3b are disposed on ferroelectric layer 5.

Insulating film 3b has preferably the thickness that can impart the electric field change due to the pyroelectric effect of ferroelectric layer 5 to two-dimensional material layer 1 without being shielded.

### Advantageous effect

In the electromagnetic wave detector, insulating film 3b is disposed between ferroelectric layer 5 and two-dimensional material layer 1.

Ferroelectric layer 5 is not in direct contact with two-dimensional material layer 1 by inserting insulating film 3b between ferroelectric layer 5 and two-dimensional material layer 1. When ferroelectric layer 5 is in direct contact with two-dimensional material layer 1, spontaneous polarization of ferroelectric layer 5 and charge exchange are performed between ferroelectric layer 5 and two-dimensional material layer 1, so that the optical response is reduced. In addition, when ferroelectric layer 5 and two-dimensional material layer 1 come into contact with each other, there is a possibility that hysteresis is generated to decrease the response speed of the electromagnetic wave detector. These effects can be suppressed by inserting insulating film 3b. In addition, even when insulating film 3b is inserted, the electric field change due to the pyroelectric effect of ferroelectric layer 5 can be applied to two-dimensional material layer 1.

In addition, when insulating film 3b absorbs the electromagnetic wave of the detection wavelength to generate heat, thermal energy can be applied to ferroelectric layer 5 by heat generation of insulating film 3b to increase the polarization change, and the sensitivity of the electromagnetic wave detector can be increased.

At this point, the configuration of the electromagnetic wave detector according to the second embodiment can also be applied to another embodiment.

### Sixth Embodiment

### Configuration of electromagnetic wave detector

In the electromagnetic wave detector of the first embodiment, the position of the end of two-dimensional material layer 1 in planar view is not particularly limited, but in the electromagnetic wave detector according to a sixth embodiment, the first portion of two-dimensional material layer 1 includes the end of two-dimensional material layer 1 in planar view. The electromagnetic wave detector of the sixth embodiment basically has the same configuration as the electromagnetic wave detector illustrated in FIG. 1 and 2, and can obtain the same effect, but the end of two-dimensional material layer 1 is disposed on semiconductor layer 4.

In other words, the end of two-dimensional material layer 1 in planar view is disposed in the opening of insulating film 3. For example, the end of two-dimensional material layer 1 is the end in the longitudinal direction of two-dimensional material layer 1.

For example, the shape of the end of the two-dimensional material layer 1 in planar view is a rectangular shape, but may be a triangular shape, a comb shape, or the like. The first portion of two-dimensional material layer 1 may have a plurality of ends electrically connected to semiconductor layer 4. The first portion of two-dimensional material layer 1 may have only a part of the end of two-dimensional material layer 1 in planar view. For example, the end of two-dimensional material layer 1 in planar view may have a portion disposed in the opening of insulating film 3 and a portion disposed on insulating film 3.

The end of two-dimensional material layer 1 may be graphene nanoribbon. In this case, because the graphene nanoribbon has a band gap, the Schottky junction is formed in the bonding region between the graphene nanoribbon and the semiconductor portion, so that the dark current can be reduced to improve the sensitivity of the electromagnetic wave detector.

### Advantageous effect

In the electromagnetic wave detector, the end of two-dimensional material layer 1 exists on semiconductor layer 4. In this case, the junction region between two-dimensional material layer 1 and the semiconductor portion is the Schottky junction. As a result, by operating two-dimensional material layer 1 and the semiconductor portion with the reverse bias, the dark current of the electromagnetic wave detector can be reduced to improve the sensitivity. In addition, by operating two-dimensional material layer 1 and the semiconductor portion with the forward bias, the photocurrent to be extracted can be amplified to improve the sensitivity.

At this point, the configuration of the electromagnetic wave detector according to the second embodiment can also be applied to another embodiment.

### Seventh embodiment

### Configuration of electromagnetic wave detector

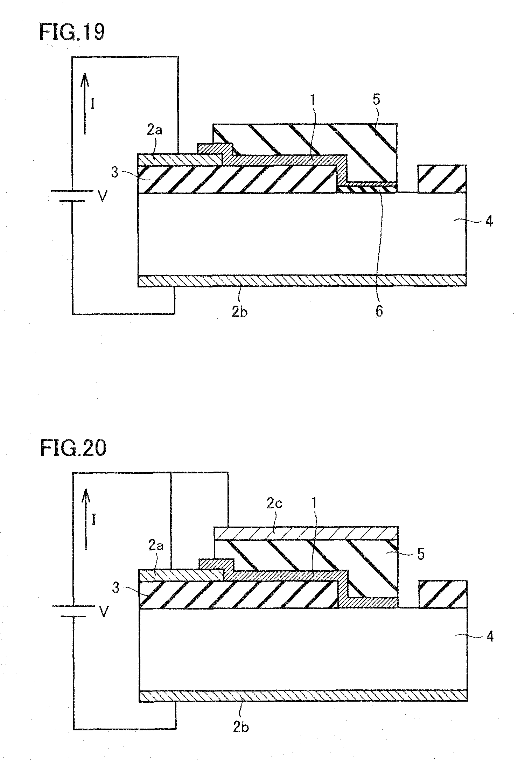

FIG. 19 is a schematic sectional view illustrating an electromagnetic wave detector according to a seventh embodiment. FIG. 19 corresponds to FIG. 1.

The electromagnetic wave detector illustrated in FIG. 19 basically has the same configuration as the electromagnetic wave detector illustrated in FIGS. 1 and 2 and can obtain the same effect, but the configuration of the connection portion between semiconductor layer 4 and two-dimensional material layer 1 is different from that of the electromagnetic wave detector illustrated in FIGS. 1 and 2. That is, the electromagnetic wave detector illustrated in FIG. 19 further includes a tunnel insulating layer 6 disposed between two-dimensional material layer 1 and semiconductor layer 4.

Tunnel insulating layer 6 is disposed inside the opening of insulating film 3. The thickness of tunnel insulating layer 6 is set such that a tunnel current is generated between two-dimensional material layer 1 and semiconductor layer 4 when the electromagnetic wave to be detected is incident on two-dimensional material layer 1 and ferroelectric layer 5. For example, the thickness of tunnel insulating layer 6 is greater than or equal to 1 nm and less than or equal to 10 nm. The material constituting tunnel insulating layer 6 may be any material having electrical insulation properties, and includes, for example, at least one selected from a group consisting of metal oxides such as alumina and hafnium oxide, or oxides including semiconductors such as silicon oxide and silicon nitride, and nitrides such as boron nitride. An arbitrary method can be used as a method for manufacturing tunnel insulating layer 6. For example, tunnel insulating layer 6 may be manufactured using an atomic layer deposition (ALD) method, a vacuum deposition method, a sputtering method, or the like. Alternatively, tunnel insulating layer 6 may be formed by oxidizing or nitriding the surface of semiconductor layer 4. Alternatively, a natural oxide film formed on the surface of semiconductor layer 4 may be used as tunnel insulating layer 6.

At this point, the configuration of the electromagnetic wave detector according to the second embodiment can also be applied to another embodiment.

### Advantageous effect

The electromagnetic wave detector includes tunnel insulating layer 6. Tunnel insulating layer 6 is disposed between two-dimensional material layer 1 and semiconductor layer 4. Tunnel insulating layer 6 has the thickness capable of forming the tunnel current between two-dimensional material layer 1 and semiconductor layer 4. In this case, the film thickness of tunnel insulating layer 6 is set to such a thickness that the tunnel injection is generated from semiconductor layer 4 to two-dimensional material layer 1, so that a large photocurrent can be injected into two-dimensional material layer 1 by improving the injection efficiency to improve the sensitivity of the electromagnetic wave detector. In addition, tunnel insulating layer 6 prevents the leakage current at the bonding interface between semiconductor layer 4 and two-dimensional material layer 1 to reduce the dark current.

### Eighth embodiment

### Configuration of electromagnetic wave detector

FIG. 20 is a schematic sectional view illustrating an electromagnetic wave detector according to an eighth embodiment. FIG. 20 corresponds to FIG. 1.

The electromagnetic wave detector illustrated in FIG. 20 basically has the same configuration as the electromagnetic wave detector illustrated in FIGS. 1 and 2 and can obtain the same effect, but the configuration of ferroelectric layer 5 is different from that of the electromagnetic wave detector illustrated in FIGS. 1 and 2. That is, the electromagnetic wave detector illustrated in FIG. 20 further includes a third electrode 2c that is in contact with ferroelectric layer 5 and is disposed on the opposite side to two-dimensional material layer 1 with respect to ferroelectric layer 5. Third electrode 2c is disposed on ferroelectric layer 5. Third electrode 2c is electrically connected to the surface of ferroelectric layer 5, and voltage V is applied between third electrode 2c and first electrode 2a or second electrode 2b.

When the electromagnetic wave is incident on ferroelectric layer 5 from the side of third electrode 2c, third electrode 2c preferably exhibits high transmittance at the wavelength of the electromagnetic wave detected by the electromagnetic wave detector.

At this point, although third electrode 2c is disposed on the opposite side of two-dimensional material layer 1, third electrode 2c may be in contact with ferroelectric layer 5, and third electrode 2c can be applied to another configuration. The direction in which the voltage is applied from third electrode 2c is preferably a direction perpendicular to the extending direction of two-dimensional material layer 1. The configuration of the electromagnetic wave detector according to the eighth embodiment can also be applied to another embodiment.

### Advantageous effect

The electromagnetic wave detector includes third electrode 2c. Third electrode 2c is electrically connected to ferroelectric layer 5. In this case, the voltage can be applied to third electrode 2c, and the polarization of ferroelectric layer 5 can be controlled. In FIG. 20, the same voltage as that of first electrode 2a is applied, but another voltage may be applied. By controlling the polarization of ferroelectric layer 5, the change in polarization due to the electromagnetic wave irradiation can be controlled, and the energy barrier between two-dimensional material layer 1 and semiconductor layer 4 can be efficiently lowered by the electromagnetic wave irradiation, so that the sensitivity of the electromagnetic wave detector is improved.

### Ninth Embodiment

### Configuration of electromagnetic wave detector

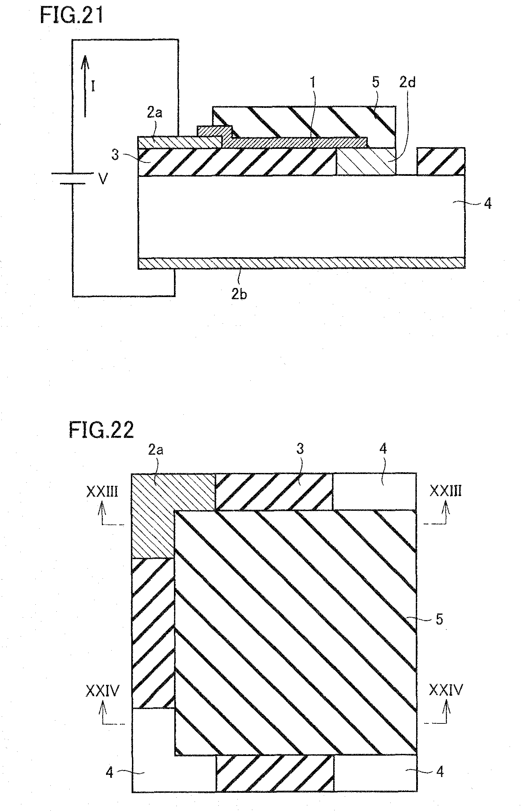

FIG. 21 is a schematic sectional view illustrating an electromagnetic wave detector according to a ninth embodiment. FIG. 21 corresponds to FIG. 1.

The electromagnetic wave detector illustrated in FIG. 21 basically has the same configuration as the electromagnetic wave detector illustrated in FIGS. 1 and 2 and can obtain the same effect, but the configuration of the connection portion between two-dimensional material layer 1 and semiconductor layer 4 is different from that of the electromagnetic wave detector illustrated in FIGS. 1 and 2. That is, the electromagnetic wave detector illustrated in FIG. 21 further includes a connection conductor 2d that electrically connects two-dimensional material layer 1 and semiconductor layer 4.

Connection conductor 2d is disposed inside the opening of insulating film 3. In planar view, connection conductor 2d is disposed so as to overlap each of two-dimensional material layer 1 and semiconductor layer 4, and is in contact with each of two-dimensional material layer 1 and semiconductor layer 4. The lower surface of connection conductor 2d is in contact with the upper surface of semiconductor layer 4. The upper surface of connection conductor 2d is in contact with the lower surface of two-dimensional material layer 1. Preferably, the position of the upper surface of connection conductor 2d is substantially the same as the position of the upper surface of insulating film 3. In other words, preferably the thickness of connection conductor 2d is equal to the thickness of insulating film 3. In this case, two-dimensional material layer 1 extends in planar shape from the upper surface of insulating film 3 to the upper surface of connection conductor 2d without being bent.

When the electromagnetic wave is incident on ferroelectric layer 5 from the side of connection conductor 2d, connection conductor 2d preferably exhibits high transmittance at the wavelength of the electromagnetic wave detected by the electromagnetic wave detector.

At this point, the configuration of the electromagnetic wave detector according to the second embodiment can also be applied to another embodiment.

### Advantageous effect

The electromagnetic wave detector includes connection conductor 2d. Connection conductor 2d electrically connects semiconductor layer 4 and two-dimensional material layer 1. In this case, the contact resistance between two-dimensional material layer 1 and semiconductor layer 4 can be reduced by providing connection conductor 2d between two-dimensional material layer 1 and semiconductor layer 4. In addition, connection conductor 2d and semiconductor layer 4 form the Schottky junction, and the dark current can be reduced.

In addition, preferably the thickness of connection conductor 2d and the thickness of insulating film 3 are substantially the same, namely, the position of the upper surface of connection conductor 2d is substantially the same as the position of the upper surface of insulating film 3. In this case, two-dimensional material layer 1 is formed horizontally without being bent, so that the carrier mobility in two-dimensional material layer 1 is improved. The optical gate effect is proportional to the mobility, so that the sensitivity of the electromagnetic wave detector is improved.

### Tenth embodiment

### Configuration of electromagnetic wave detector

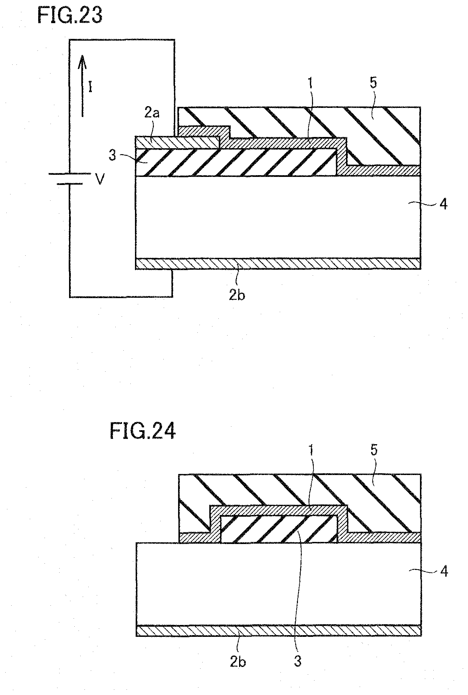

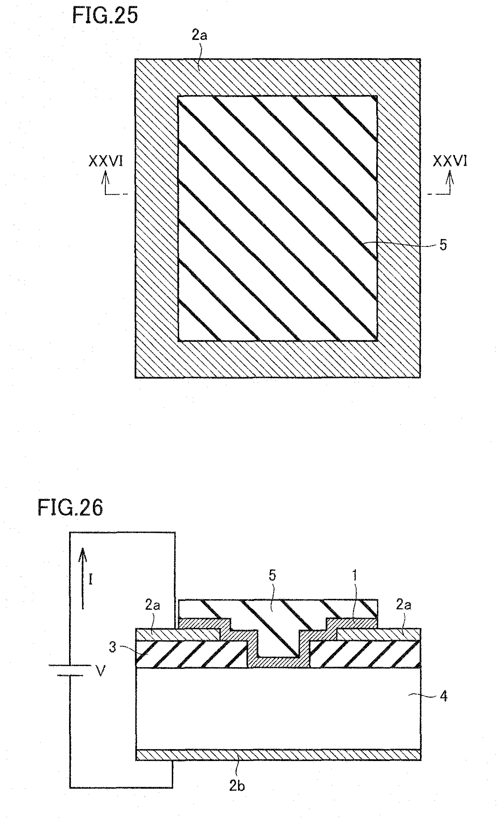

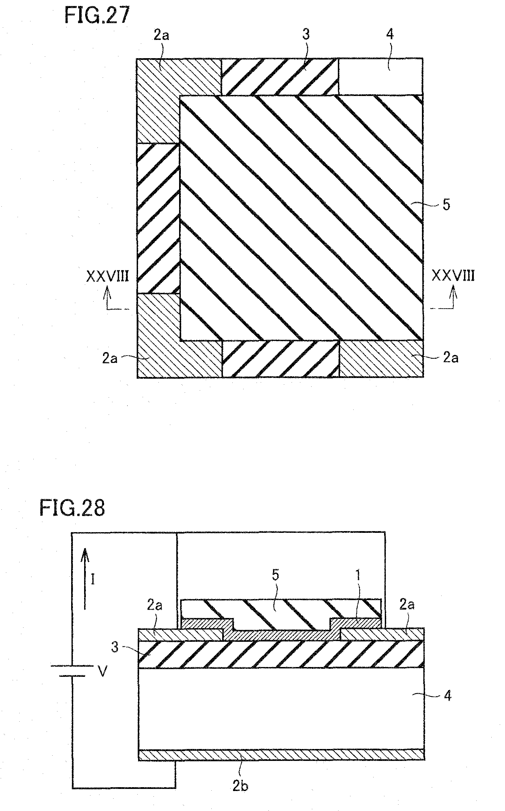

FIG. 22 is a schematic plan view illustrating an electromagnetic wave detector according to a tenth embodiment. FIG. 23 is a schematic sectional view taken along a line XXIII-XXIII in FIG. 22. FIG. 24 is a schematic sectional view taken along a line XXIV-XXIV in FIG. 22. FIG. 25 is a schematic plan view illustrating a first modification of the electromagnetic wave detector of the tenth embodiment. FIG. 26 is a schematic sectional view taken along a line XXVI-XXVI in FIG. 25. FIG. 27 is a schematic plan view illustrating a second modification of the electromagnetic wave detector according to the tenth embodiment. FIG. 28 is a schematic sectional view taken along a line XXVIII-XXVIII in FIG. 27.

The electromagnetic wave detector illustrated in FIG. 22 basically has the same configuration as the electromagnetic wave detector illustrated in FIGS. 1 and 2 and can obtain the same effect, but the configurations of two-dimensional material layer 1 and insulating film 3 are different from those of the electromagnetic wave detector illustrated in FIGS. 1 and 2. That is, the electromagnetic wave detector illustrated in FIG. 22 is different from the electromagnetic wave detector illustrated in FIGS. 1 and 2 in that a plurality of connection portions between two-dimensional material layer 1 and semiconductor layer 4 are provided.

In the electromagnetic wave detector illustrated in FIG. 22, a plurality of openings are formed as openings in insulating film 3. Two-dimensional material layer 1 extends to the inside of each of the plurality of openings and is electrically connected to semiconductor layer 4 inside each of the plurality of openings. In the insulating film 3, a first opening, a second opening, and a third opening are formed as a plurality of openings. The first opening, the second opening, and the third opening are disposed to be spaced apart from each other. Each of the first opening, the second opening, and the third opening penetrates insulating film 3, and the surface of semiconductor layer 4 is exposed at the bottom. Two-dimensional material layer 1 extends from the upper surface of insulating film 3 to the insides of the first opening, the second opening, and the third opening. Two-dimensional material layer 1 is in contact with semiconductor layer 4 at the bottoms of the first opening, the second opening, and the third opening.

As described above, the plurality of openings are provided in insulating film 3 to increase the contact region between two-dimensional material layer 1 and semiconductor layer 4, so that the current flowing from semiconductor layer 4 to two-dimensional material layer 1 can be dispersed. For this reason, the region where two-dimensional material layer 1 is affected by the electric field change through ferroelectric layer 5 can be expanded.

For example, the case where the electromagnetic wave detector using the tenth embodiment is one pixel will be considered. For example, the electromagnetic wave detector illustrated in FIG. 22 is assumed to be one pixel having a quadrangular planar shape. In FIGS. 22 to 24, when the electromagnetic wave is incident on ferroelectric layer 5 from the side of first electrode 2a, preferably the area of first electrode 2a is reduced as much as possible in order to reduce the attenuation of the electromagnetic wave incident on ferroelectric layer 5. Therefore, as illustrated in FIGS. 22 and 23, first electrode 2a is disposed at one of the four corners of the pixel. Then, as illustrated in FIGS. 22 to 24, the first opening, the second opening, and the third opening of insulating film 3 are disposed at other three corners. In this way, the contact area between two-dimensional material layer 1 and ferroelectric layer 5 can be increased while the attenuation of the electromagnetic wave by first electrode 2a is minimized. As a result, the region affected by the change in the electric field from ferroelectric layer 5 can be widened in two-dimensional material layer 1 to increase the sensitivity of the electromagnetic wave detector. The areas of the opening portions of first electrode 2a and insulating film 3 are preferably as small as possible.

Although the plurality of connection portions with semiconductor layer 4 are provided in FIGS. 22 to 24, the plurality of connection portions between two-dimensional material layer 1 and first electrode 2a may be provided as illustrated in FIGS. 27 and 28. For example, each of the plurality of first electrodes 2a is disposed at two or more of the four corners of the pixel. Each of the plurality of first electrodes 2a may be disposed at another position as long as it is on insulating film 3.

The plurality of connection portions between two-dimensional material layer 1 and semiconductor layer 4 and the plurality of connection portions between two-dimensional material layer 1 and first electrode 2a may be provided. For example, each of the connection portion between two-dimensional material layer 1 and semiconductor layer 4 and the connection portion between two-dimensional material layer 1 and first electrode 2a may be disposed at two of the four corners of the pixel.

The electromagnetic wave detector illustrated in FIGS. 25 and 26 basically has the same configuration as the electromagnetic wave detector illustrated in FIG. 22 and can obtain the same effect, but the configurations of first electrode 2a and insulating film 3 are different from those of the electromagnetic wave detector illustrated in FIG. 22. That is, in the electromagnetic wave detector illustrated in FIG. 25, first electrode 2a is formed in an annular shape, and the first portion of two-dimensional material layer 1 is disposed inside first electrode 2a. For example, first electrode 2a is disposed on an outer periphery of the pixel. The opening of insulating film 3 is disposed inside first electrode 2a, and for example, is disposed at the center of the pixel. First electrode 2a is disposed on the upper surface of insulating film 3 so as to surround the outer periphery of the opening of insulating film 3. In the electromagnetic wave detector illustrated in FIG. 25, the photocurrent extracted from semiconductor layer 4 through two-dimensional material layer 1 increases as compared with the electromagnetic wave detector illustrated in FIG. 22, so that the detection sensitivity is high. The width of first electrode 2a is preferably as narrow as possible in order to suppress the attenuation of the electromagnetic wave. Two-dimensional material layer 1 may be disposed in a region that partially overlaps with the opening of insulating film 3 and first electrode 2a and substantially overlaps with the planar shape of semiconductor layer 4.

At this point, the configuration of the electromagnetic wave detector according to the tenth embodiment can also be applied to another embodiment.

### Advantageous effect

In the electromagnetic wave detector illustrated in FIGS. 22 to 24 and 27, a plurality of at least one of the connection portion between two-dimensional material layer 1 and semiconductor layer 4 and the connection portion between two-dimensional material layer 1 and first electrode 2a are provided.

Because a plurality of at least one of the connection portion between two-dimensional material layer 1 and semiconductor layer 4 and the connection portion between two-dimensional material layer 1 and first electrode 2a are provided, the current flowing between semiconductor layer 4 and first electrode 2a through two-dimensional material layer 1 does not flow locally but flows in a dispersed manner in two-dimensional material layer 1. As a result, in the electromagnetic wave detector illustrated in FIGS. 22 to 24 and 27, the region where the current can change in two-dimensional material layer 1 due to the change in polarization in ferroelectric layer 5 is widened as compared with the case where only one connection portion is provided, and thus, the detection sensitivity is high.

In the electromagnetic wave detector illustrated in FIGS. 25 and 26, first electrode 2a is formed in an annular shape, and the first portion of two-dimensional material layer 1 is disposed inside first electrode 2a. In this case, it is possible to expand the region affected by the change in the electric field from semiconductor layer 4 in two-dimensional material layer 1 while the attenuation of the electromagnetic wave by first electrode 2a is minimized. As a result, the sensitivity of the electromagnetic wave detector can be increased.

### Eleventh embodiment

### Configuration of electromagnetic wave detector

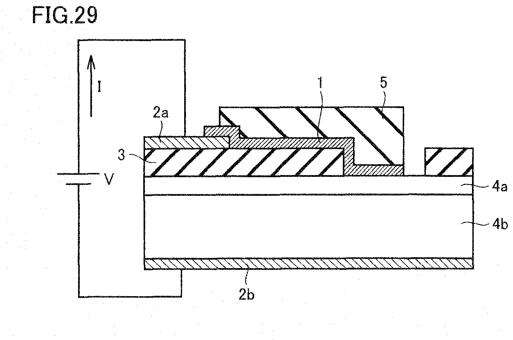

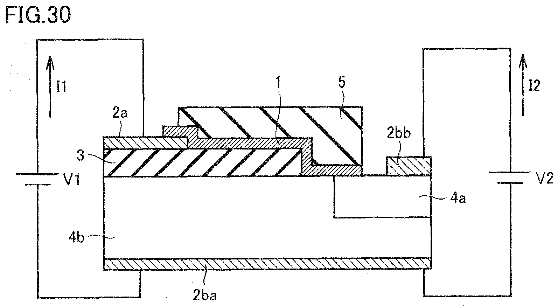

FIG. 29 is a schematic sectional view illustrating an electromagnetic wave detector according to an eleventh embodiment. FIG. 30 is a schematic sectional view illustrating a modification of the electromagnetic wave detector according to the eleventh embodiment.

The electromagnetic wave detector illustrated in FIG. 29 basically has the same configuration as the electromagnetic wave detector illustrated in FIGS. 1 and 2 and can obtain the same effect, but the configuration of semiconductor layer 4 is different from that of the electromagnetic wave detector illustrated in FIGS. 1 and 2. That is, the electromagnetic wave detector illustrated in FIG. 29 is different from the electromagnetic wave detector illustrated in FIGS. 1 and 2 in that semiconductor layer 4 includes a semiconductor layer 4a (first semiconductor portion) and a semiconductor layer 4b (second semiconductor portion).

As illustrated in FIG. 29, for example, semiconductor layer 4 is constituted of semiconductor layers 4a and 4b. Semiconductor layer 4 may include at least three semiconductor layers. Semiconductor layer 4a is exposed at the opening of insulating film 3, and is electrically connected to first electrode 2a with two-dimensional material layer 1 interposed therebetween. For example, semiconductor layer 4a is in contact with two-dimensional material layer 1 and insulating film 3. For example, semiconductor layer 4b is disposed on the opposite side of two-dimensional material layer 1 with respect to semiconductor layer 4a and is electrically connected to second electrode 2b. Although semiconductor layer 4a and semiconductor layer 4b are laminated in FIG. 29, the present invention is not limited thereto.

The conductivity type of semiconductor layer 4a is different from the conductivity type of semiconductor layer 4b. For example, the conductivity type of semiconductor layer 4a is the n-type, and the conductivity type of semiconductor layer 4b is the p-type. Thus, semiconductor layer 4 constitutes a diode. For example, semiconductor layer 4 constitutes a photodiode having the sensitivity to the wavelength different from that of ferroelectric layer 5.

The electromagnetic wave detector illustrated in FIG. 30 basically has the same configuration as the electromagnetic wave detector illustrated in FIG. 29 and can obtain the same effect. However, the electromagnetic wave detector illustrated in FIG. 30 differs from the electromagnetic wave detector illustrated in FIG. 29 in further including a fourth electrode electrically connected to semiconductor layer 4a (first semiconductor portion) in addition to a second electrode 2ba electrically connected to semiconductor layer 4b (second semiconductor portion).

Two-dimensional material layer 1 is electrically connected to semiconductor layer 4a and semiconductor layer 4b. The interface between semiconductor layer 4a and semiconductor layer 4b is disposed in the opening of insulating film 3. For example, semiconductor layer 4a is in contact with two-dimensional material layer 1 and a fourth electrode 2bb. For example, semiconductor layer 4b is in contact with two-dimensional material layer 1 and insulating film 3 in addition to second electrode 2b.

As illustrated in FIG. 30, voltage V2 is applied between second electrode 2ba and fourth electrode 2bb. At this time, the depletion layer is formed at the interface between semiconductor layer 4a and semiconductor layer 4b by applying voltage V2 with the reverse bias, so that the depletion layer is formed at the interface between two-dimensional material layer 1 and semiconductor layer 4a and semiconductor layer 4b.

At this point, the configuration of the electromagnetic wave detector according to the tenth embodiment can also be applied to another embodiment.

### Advantageous effect

In the electromagnetic wave detector, semiconductor layer 4 includes semiconductor layer 4a and semiconductor layer 4b. Semiconductor layer 4a and semiconductor layer 4b form the pn junction, so that the dark current can be reduced. In addition, semiconductor layer 4a and semiconductor layer 4b constitute the photodiode having the sensitivity to the wavelength different from that of ferroelectric layer 5, so that ferroelectric layer 5 and the photodiode can detect a broadband wavelength.

### Twelfth embodiment

### Configuration of electromagnetic wave detector

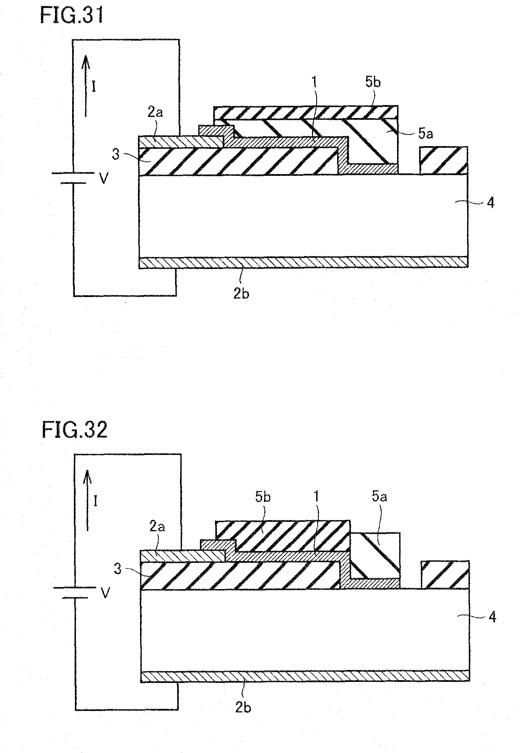

FIG. 31 is a schematic sectional view illustrating an electromagnetic wave detector according to a twelfth embodiment. FIG. 32 is a schematic sectional view illustrating a modification of the electromagnetic wave detector according to the twelfth embodiment.

The electromagnetic wave detector illustrated in FIG. 31 basically has the same configuration as the electromagnetic wave detector illustrated in FIGS. 1 and 2 and can obtain the same effect, but the configuration of ferroelectric layer 5 is different from that of the electromagnetic wave detector illustrated in FIGS. 1 and 2. That is, the electromagnetic wave detector illustrated in FIG. 31 is different from the electromagnetic wave detector illustrated in FIGS. 1 and 2 in that ferroelectric layer 5 includes a ferroelectric layer 5a (first ferroelectric portion) and a ferroelectric layer 5b (second ferroelectric portion).

As described above, the material constituting each of ferroelectric layer 5a and ferroelectric layer 5b may be any ferroelectric in which the polarization change is generated in response to the change in thermal energy, and the absorption wavelengths of the electromagnetic waves are preferably different from each other.

As illustrated in FIG. 31, for example, ferroelectric layer 5 includes ferroelectric layer 5a and ferroelectric layer 5b. Ferroelectric layer 5 may include at least three ferroelectric layers. Ferroelectric layer 5a is disposed on the side of two-dimensional material layer 1 with respect to ferroelectric layer 5b, and is in contact with two-dimensional material layer 1. Ferroelectric layer 5b is in contact with ferroelectric layer 5a, but is not in contact with two-dimensional material layer 1. Although ferroelectric layer 5a and ferroelectric layer 5b are laminated in FIG. 31, the present invention is not limited thereto.

The electromagnetic wave detector illustrated in FIG. 32 basically has the same configuration as the electromagnetic wave detector illustrated in FIG. 31 and can obtain the same effect, but the configuration of ferroelectric layer 5 is different from that of the electromagnetic wave detector illustrated in FIG. 31. That is, the electromagnetic wave detector illustrated in FIG. 32 is different from the electromagnetic wave detector illustrated in FIG. 31 in that ferroelectric layer 5a and ferroelectric layer 5b are in contact with two-dimensional material layer 1.

Ferroelectric layer 5a is disposed so as to overlap with the first portion of two-dimensional material layer 1. Ferroelectric layer 5b is disposed so as to overlap with the second portion and the third portion of two-dimensional material layer 1. Polarizabilities of the materials constituting ferroelectric layer 5a and ferroelectric layer 5b are different from each other. Preferably, the polarizability of the material constituting each of ferroelectric layer 5a and ferroelectric layer 5b is designed such that the Fermi level in each region of two-dimensional material layer 1 is optimized. For example, the polarizability of the material constituting ferroelectric layer 5a is set higher than the polarizability of the material constituting ferroelectric layer 5b.

### Advantageous effect

In the electromagnetic wave detector, ferroelectric layer 5 includes ferroelectric layer 5a and ferroelectric layer 5b. In the electromagnetic wave detector of FIG. 31, the absorption wavelengths of the electromagnetic waves of ferroelectric layer 5a and ferroelectric layer 5b are different from each other, so that the broadband wavelength can be detected as compared with the case where the absorption wavelengths of the electromagnetic waves of the materials constituting ferroelectric layer 5a and ferroelectric layer 5b are equal to each other. In the electromagnetic wave detector of FIG. 32, the polarizabilities of the materials constituting ferroelectric layer 5a and ferroelectric layer 5b are different from each other, the electromagnetic wave detector can be designed such that the Fermi level in each region of two-dimensional material layer 1 is optimized. The performance of the electromagnetic wave detector is improved by optimally designing the Fermi level in each region of two-dimensional material layer 1.

### Thirteenth embodiment

### Configuration of electromagnetic wave detector

The electromagnetic wave detector according to a thirteenth embodiment is different from the electromagnetic wave detector illustrated in FIGS. 1 and 2 in that two-dimensional material layer 1 includes a turbulent layer structure.

In the electromagnetic wave detector, a region corresponding to the channel region in two-dimensional material layer 1 is the turbulent layer structure portion. At this point, the turbulent layer structure is a region in which a plurality of graphene layers are laminated, and means a structure in which the laminated graphene layers are laminated while lattices of the laminated graphene layers are mismatched. Entire two-dimensional material layer 1 may have the turbulent layer structure, or only a part thereof may have the turbulent layer structure.

Any method can be used as a method for producing the turbulent layer structure portion. For example, a single-layer graphene prepared by a CVD method may be transferred multiple times, and the multilayer graphene may be laminated to form the turbulent layer structure portion. In addition, the graphene may be grown on the graphene by the CVD method using ethanol, methane, or the like as a carbon source to form the turbulent layer structure portion. When the contact region with insulating film 3 in two-dimensional material layer 1 has the turbulent layer structure, the carrier mobility in two-dimensional material layer 1 is improved. Here, the normal laminated graphene is called A-B lamination, and is laminated while lattices of the laminated graphene are matched. However, the graphene produced by the CVD method is polycrystalline, and in the case where the graphene is transferred on the graphene multiple times, or in the case where the graphene is laminated on the underlying graphene by the CVD method, the turbulent layer structure in which the lattices of the laminated graphenes are mismatched is obtained.

The graphene having the turbulent layer structure has little influence of interlayer interaction and has properties equivalent to those of single-layer graphene. Furthermore, the mobility of two-dimensional material layer 1 decreases due to the influence of carrier scattering in underlying insulating film 3. However, the graphene having the turbulent layer structure in contact with insulating film 3 is affected by the carrier scattering, but the upper-layer graphene laminated on the graphene in the turbulent layer structure is hardly affected by the carrier scattering of underlying insulating film 3. In addition, in the graphene having the turbulent layer structure, the influence of the interlayer interaction is small, and thus the conductivity is also improved. As described above, in the graphene having the turbulent layer structure, the carrier mobility can be improved. As a result, the sensitivity of the electromagnetic wave detector can be improved.

In addition, the graphene having the turbulent layer structure may be applied only to a portion of two-dimensional material layer 1 existing on insulating film 3. For example, for a contact region with semiconductor layer 4 and a contact region with first electrode 2a in two-dimensional material layer 1, the graphene that is not the turbulent layer structure, for example, the single-layer graphene may be used. In this case, the influence of the carrier scattering of insulating film 3 on two-dimensional material layer 1 can be prevented without increasing a contact resistance between first electrode 2a and semiconductor layer 4 and two-dimensional material layer 1.

At this point, the configuration of the electromagnetic wave detector according to the tenth embodiment can also be applied to another embodiment.

### Advantageous effect

In the electromagnetic wave detector, two-dimensional material layer 1 includes the turbulent layer structure. In this case, the carrier mobility in two-dimensional material layer 1 can be improved. As a result, the sensitivity of the electromagnetic wave detector can be improved.

### Fourteenth embodiment

### Configuration of electromagnetic wave detector

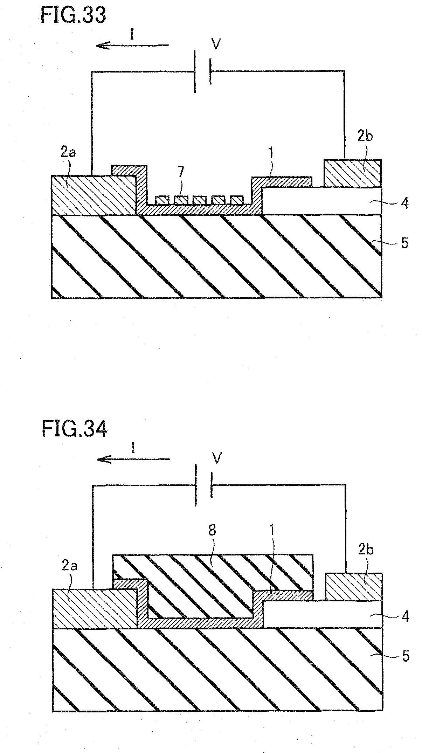

FIG. 33 is a schematic sectional view illustrating an electromagnetic wave detector according to a fourteenth embodiment.

The electromagnetic wave detector illustrated in FIG. 33 basically has the same configuration as the electromagnetic wave detector illustrated in FIGS. 1 and 2 and can obtain the same effect, but the configurations of two-dimensional material layer 1 are different from those of the electromagnetic wave detector illustrated in FIGS. 1 and 2. That is, the electromagnetic wave detector illustrated in FIG. 33 is different from the electromagnetic wave detector illustrated in FIGS. 1 and 2 in that at least one of conductor 7 is formed on the upper surface of two-dimensional material layer 1. A plurality of conductors 7 are disposed on the upper surface of two-dimensional material layer 1. The plurality of conductors 7 are disposed to be spaced apart from each other. The conductor 7 is a floating electrode. The details will be described below.

As illustrated in FIG. 33, in the electromagnetic wave detector according to the fourteenth embodiment, conductor 7 as the floating electrode is provided on two-dimensional material layer 1. Any material can be used as the material constituting conductor 7 as long as the material is the conductor. For example, a metal material such as gold (Au), silver (Ag), copper (Cu), aluminum (Al), nickel (Ni), chromium (Cr), or palladium (Pd) can be used as the material of conductor 7. At this point, conductor 7 is not connected to a power supply circuit or the like, but is floating.

Conductor 7 is provided on two-dimensional material layer 1 located between first electrode 2a and semiconductor layer 4. The plurality of conductors 7 has a one-dimensional or two-dimensional periodic structure. For example, a structure in which the plurality of conductors 7 are arranged to be spaced apart from each other (periodically) in the horizontal direction on the paper surface of FIG. 33 or in the depth direction on the paper surface may be adopted as an example of the one-dimensional periodic structure. Furthermore, a structure in which the conductors 7 are arranged at positions corresponding to lattice points such as a square lattice or a triangular lattice in planar view of the electromagnetic wave detector can be adopted as an example of the two-dimensional periodic structure. In planar view of the electromagnetic wave detector, the planar shape of each conductor 7 may be any shape such as a circular shape, a triangular shape, a quadrangular shape, a polygonal shape, or an elliptical shape. In addition, the arrangement of conductor 7 in planar view is not limited to the above-described array having periodic symmetry, but may be an array having asymmetry in planar view. At this point, any method can be adopted as a specific method for forming conductor 7, but for example, a method similar to the method for manufacturing first electrode 2a described in the first embodiment may be used.

In the electromagnetic wave detector according to the fourteenth embodiment, conductor 7 that is the floating electrode is provided on two-dimensional material layer 1. Therefore, the surface carrier generated by the irradiation of the electromagnetic wave in ferroelectric layer 5 can move back and forth between the plurality of conductors 7, and as a result, the lifetime of the photocarriers becomes long. Accordingly, the sensitivity of the electromagnetic wave detector can be enhanced.

In addition, when the plurality of conductors 7 are arranged to form the one-dimensional periodic structure, and the material of conductor 7 is a material that causes surface plasmon resonance, polarization dependency is generated in conductor 7 due to the irradiated electromagnetic wave. As a result, semiconductor layer 4 of the electromagnetic wave detector can be irradiated with only the electromagnetic wave of the specific polarization. In this case, the electromagnetic wave detector according to the fourteenth embodiment can detect only specific polarized light.

In addition, the plurality of conductors 7 are arranged so as to form the two-dimensional periodic structure, and the material of conductor 7 is a material that causes the surface plasmon resonance, whereby the electromagnetic wave of a specific wavelength can be resonated by the plurality of conductors 7. In this case, only the electromagnetic wave having the specific wavelength can be detected by the electromagnetic wave detector. In this case, the electromagnetic wave detector according to the fourteenth embodiment can detect only the electromagnetic wave of the specific wavelength with high sensitivity.

In the case where the plurality of conductors 7 are formed so as to be asymmetrical in planar view, as in the case where the plurality of conductors 7 have the one-dimensional periodic structure, polarization dependency is generated in conductors 7 with respect to the irradiated electromagnetic wave. As a result, semiconductor layer 4 can be irradiated with only the electromagnetic wave of the specific polarization. In this case, the electromagnetic wave detector according to the fourteenth embodiment can detect only specific polarized light.

In the electromagnetic wave detector, conductor 7 may be disposed under two-dimensional material layer 1. Even with such a configuration, the same effects as those of the electromagnetic wave detector illustrated in FIG. 33 can be obtained. Furthermore, in this case, two-dimensional material layer 1 is not damaged during the formation of conductor 7, so that the decrease in the mobility of the carrier in two-dimensional material layer 1 can be prevented.

The irregularities may be formed on two-dimensional material layer 1. In this case, the irregularities of two-dimensional material layer 1 may have the periodic structure or the asymmetric structure similarly to the plurality of conductors 7 described above. In this case, the same effect as in the case of forming the plurality of conductors 7 can be obtained.

At this point, the configuration of the electromagnetic wave detector according to the tenth embodiment can also be applied to another embodiment.

### Advantageous effect

The electromagnetic wave detector further includes at least one conductor 7. At least one conductor 7 is disposed to contact two-dimensional material layer 1. In this case, the lifetime of the photocarrier in two-dimensional material layer 1 becomes long. As a result, the sensitivity of the electromagnetic wave detector can be enhanced.

### Fifteenth embodiment

### Configuration of electromagnetic wave detector

FIG. 34 is a schematic sectional view illustrating an electromagnetic wave detector according to a fifteenth embodiment.

The electromagnetic wave detector illustrated in FIG. 34 basically has the same configuration as the electromagnetic wave detector illustrated in FIGS. 1 and 2 and can obtain the same effect, but the configuration on two-dimensional material layer 1 is different from that of the electromagnetic wave detector illustrated in FIGS. 1 and 2. That is, the electromagnetic wave detector illustrated in FIG. 34 is different from the electromagnetic wave detector illustrated in FIGS. 1 and 2 in that at least one contact layer 8 is formed on the upper surface of two-dimensional material layer 1. The details will be described below.

In the electromagnetic wave detector illustrated in FIG. 34, contact layer 8 is provided on two-dimensional material layer 1. Contact layer 8 is made of a material capable of supplying the hole or electron to two-dimensional material layer 1 by contacting two-dimensional material layer 1. Contact layer 8 allows two-dimensional material layer 1 to be optionally doped with the hole or electron.

For example, a composition containing a photosensitizer having a quinone diazite group and a novolak resin, which is called a positive photoresist, can be used as contact layer 8. For example, a material having a polar group can be used as the material constituting contact layer 8. For example, a material having an electron-withdrawing group, which is an example of the material, has an effect of reducing the electron density of two-dimensional material layer 1. In addition, a material having an electron donating group, which is an example of the material, has an effect of increasing the electron density of two-dimensional material layer 1. Examples of the material having an electron-withdrawing group include materials having a halogen, a nitrile, a carboxyl group, or a carbonyl group. Examples of the material having an electron donating group include materials having an alkyl group, an alcohol, an amino group, or a hydroxyl group. In addition to the above, a material in which charge bias is generated in the entire molecule due to the polar group can also be used as the material of contact layer 8.

In addition, even in an organic substance, a metal, a semiconductor, an insulator, a two-dimensional material, or a mixture of any of these materials, any material can be used as the material of contact layer 8 as long as it is a material in which the charge bias is generated in the molecule to generate the polarity. Here, when contact layer 8 made of an inorganic substance and two-dimensional material layer 1 are brought into contact with each other, the conductivity type with which two-dimensional material layer 1 is doped is the p-type when the work function of contact layer 8 is larger than the work function of two-dimensional material layer 1, and the n-type when the work function of contact layer 8 is smaller than the work function of two-dimensional material layer 1. On the other hand, when contact layer 8 is an organic substance, the organic substance that is a material constituting contact layer 8 does not have the clear work function. Therefore, whether two-dimensional material layer 1 is the n-type doped or the p-type doped is preferably determined by determining the polar group of the material of contact layer 8 based on the polarity of the organic molecule used for contact layer 8.

For example, when a composition called a positive photoresist containing a photosensitizer having a quinone diazite group and a novolak resin is used as contact layer 8, a region where a resist is formed in two-dimensional material layer 1 by a photolithography process is a p-type two-dimensional material layer region. This eliminates the need for processing for forming the mask in contact with the surface of two-dimensional material layer 1. As a result, it is possible to reduce process damage to two-dimensional material layer 1 and simplify the process.

In the electromagnetic wave detector according to the fifteenth embodiment, contact layer 8 is formed on two-dimensional material layer 1. As described above, for example, using the material having the electron withdrawing group or the material having the electron donating group as the material of contact layer 8, the state (conductivity type) of two-dimensional material layer 1 can be intentionally made the n-type or the p-type. In this case, the carrier doping of two-dimensional material layer 1 can be controlled without considering the influence of the carrier doping from the polarization of first electrode 2a, semiconductor layer 4, and ferroelectric layer 5. As a result, the performance of the electromagnetic wave detector can be improved.

A gradient of the charge density is formed in two-dimensional material layer 1 by forming contact layer 8 only on one of the side of first electrode 2a and the side of semiconductor layer 4 on the upper surface of two-dimensional material layer 1. As a result, the mobility of the carrier in two-dimensional material layer 1 is improved, and the sensitivity of the electromagnetic wave detector can be increased.

The plurality of contact layers 8 may be formed on two-dimensional material layer 1. The number of contact layers 8 may be greater than or equal to three, and may be any number. The plurality of contact layers 8 may be formed on two-dimensional material layer 1 located between first electrode 2a and semiconductor layer 4. In this case, the materials of the plurality of contact layers 8 may be the same material or different materials.

In the electromagnetic wave detector of the fifteenth embodiment, the film thickness of contact layer 8 is preferably sufficiently thin such that photoelectric conversion can be performed when two-dimensional material layer 1 is irradiated with the electromagnetic wave. On the other hand, contact layer 8 is formed so as to have the thickness that allows the carrier to be doped from contact layer 8 to two-dimensional material layer 1. Contact layer 8 may have any configuration as long as the carrier such as the molecule or the electron is introduced into two-dimensional material layer 1. For example, two-dimensional material layer 1 is immersed in a solution to supply the carrier to two-dimensional material layer 1 at the molecular level, so that the carrier may be doped to two-dimensional material layer 1 without forming solid contact layer 8 on two-dimensional material layer 1.

In addition, as the material of contact layer 8, a material that causes polarity conversion may be used in addition to the above-described materials. In this case, when contact layer 8 performs the polarity conversion, the electron or hole generated during the conversion is supplied to two-dimensional material layer 1. Accordingly, the doping of the electron or hole is generated in the portion of two-dimensional material layer 1 with which contact layer 8 is in contact. Accordingly, even when contact layer 8 is removed, the portion of two-dimensional material layer 1 in contact with contact layer 8 remains doped with the electron or hole. Consequently, when the material that causes the polarity conversion is used as contact layer 8, contact layer 8 may be removed from two-dimensional material layer 1 after a certain time elapses. In this case, the opening area of two-dimensional material layer 1 increases as compared with the case where contact layer 8 exists. For this reason, the detection sensitivity of the electromagnetic wave detector can be improved. At this point, the polar conversion is a phenomenon in which the polar group is chemically converted, and for example, means a phenomenon in which the electron withdrawing group is changed to the electron donating group, or the electron donating group is changed to the electron withdrawing group, or the polar group is changed to a nonpolar group, or a nonpolar group is changed to the polar group.

In addition, contact layer 8 may be formed of a material that causes the polarity conversion by the electromagnetic wave irradiation. In this case, by selecting the material that causes the polarity conversion at a specific wavelength of the electromagnetic wave as the material of contact layer 8, the polarity conversion can be caused in contact layer 8 only when the electromagnetic wave of the specific wavelength of the electromagnetic wave is irradiated, and doping into two-dimensional material layer 1 can be performed. As a result, the photocurrent flowing into two-dimensional material layer 1 can be increased.

In addition, a material that causes an oxidation-reduction reaction by electromagnetic wave irradiation may be used as the material of contact layer 8. In this case, the electron or hole generated during the oxidation-reduction reaction can be doped in two-dimensional material layer 1.

At this point, the configuration of the electromagnetic wave detector according to the tenth embodiment can also be applied to another embodiment.

### Advantageous effect

The electromagnetic wave detector includes contact layer 8 in contact with two-dimensional material layer 1. Contact layer 8 supplies the hole or electron to two-dimensional material layer 1. In this case, the carrier doping of two-dimensional material layer 1 can be controlled without considering the influence of the carrier doping from first electrode 2a and semiconductor layer 4. As a result, the performance of the electromagnetic wave detector can be improved.

### Sixteenth embodiment

### Configuration of electromagnetic wave detector

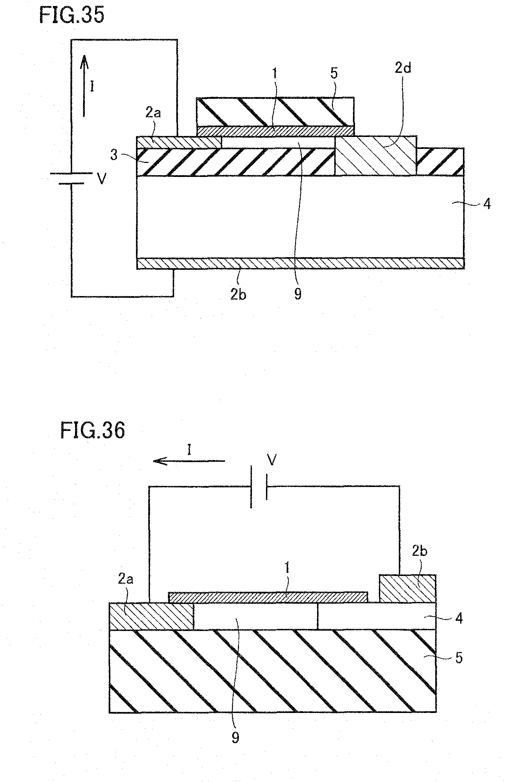

FIG. 35 is a schematic sectional view illustrating an electromagnetic wave detector according to a sixteenth embodiment. FIG. 36 is a schematic sectional view illustrating a modification of the electromagnetic wave detector according to the sixteenth embodiment. The electromagnetic wave detector illustrated in FIG. 35 basically has the same configuration as the electromagnetic wave detector illustrated in FIGS. 1 and 2 and can obtain the same effect, but is different from the electromagnetic wave detector illustrated in FIGS. 1 and 2 in that a gap 9 is formed around two-dimensional material layer 1.

As illustrated in FIG. 35, gap 9 is provided between two-dimensional material layer 1 and insulating film 3. Two-dimensional material layer 1 has a surface facing gap 9. That is, two-dimensional material layer 1 is not in contact with insulating film 3 unlike the electromagnetic wave detector according to the first embodiment. At this time, the upper surface of semiconductor layer 4 in the opening has preferably the same height as that of the upper surface of first electrode 2a. Two-dimensional material layer 1 extends from above first electrode 2a to above semiconductor layer 4. Gap 9 located below two-dimensional material layer 1 is located between first electrode 2a and the opening. Another configuration may be adopted as long as gap 9 is provided between insulating film 3 and two-dimensional material layer 1.

The electromagnetic wave detector illustrated in FIG. 36 basically has the same configuration as the electromagnetic wave detector illustrated in FIG. 35 and can obtain the same effect, but the structure of two-dimensional material layer 1 is different from that of the electromagnetic wave detector illustrated in FIG. 35. That is, in the electromagnetic wave detector illustrated in FIG. 36, gap 9 is formed between two-dimensional material layer 1 and ferroelectric layer 5.

As illustrated in FIG. 36, gap 9 is provided between two-dimensional material layer 1 and ferroelectric layer 5. That is, two-dimensional material layer 1 is not in contact with ferroelectric layer 5 unlike the electromagnetic wave detector according to the first embodiment. The polarization change of ferroelectric layer 5 caused by the electromagnetic wave irradiation causes the electric field change in two-dimensional material layer 1 through first electrode 2a or semiconductor layer 4. At this time, the polarization direction of ferroelectric layer 5 may be a direction parallel to the surface of two-dimensional material layer 1. The electric field change may be generated through gap 9. At this time, the polarization direction of ferroelectric layer 5 may be a direction perpendicular to the surface of two-dimensional material layer 1. The upper surface of semiconductor layer 4 has preferably the same height as that of the upper surface of first electrode 2a. Two-dimensional material layer 1 extends from above first electrode 2a to above semiconductor layer 4. Gap 9 located below two-dimensional material layer 1 is located between first electrode 2a and semiconductor layer 4. Another configuration may be adopted as long as gap 9 is provided between two-dimensional material layer 1 and ferroelectric layer 5.

At this point, the configuration of the electromagnetic wave detector according to the tenth embodiment can also be applied to another embodiment.

### Advantageous effect

In the electromagnetic wave detector, gap 9 is formed in at least one of the upper portion and the lower portion of two-dimensional material layer 1. In this case, it is possible to eliminate the influence of carrier scattering caused by the contact between the insulating film 3 or the ferroelectric layer 5 and the two-dimensional material layer 1. As a result, a decrease in carrier mobility in the two-dimensional material layer 1 can be suppressed. Therefore, the sensitivity of the electromagnetic wave detector can be improved. The optical gate effect can be exerted even when gap 9 is generated below two-dimensional material layer 1.

### Seventeenth embodiment

### Configuration of electromagnetic wave detector

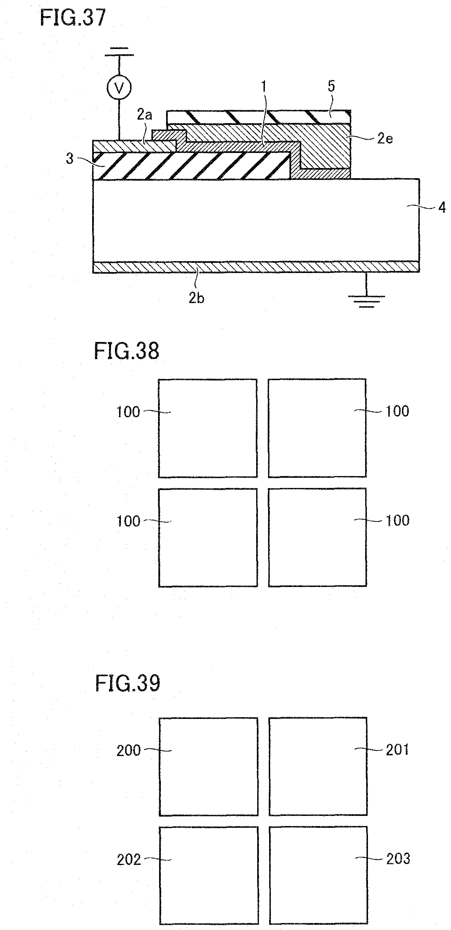

FIG. 37 is a schematic sectional view illustrating an electromagnetic wave detector according to a seventeenth embodiment. The electromagnetic wave detector illustrated in FIG. 37 basically has the same configuration as the electromagnetic wave detector illustrated in FIGS. 1 and 2 and can obtain the same effect. However, the electromagnetic wave detector illustrated in FIG. 37 is different from the electromagnetic wave detector illustrated in FIGS. 1 and 2 in that the electromagnetic wave detector illustrated in FIG. 37 further includes a connection conductor 2e that electrically connects two-dimensional material layer 1 and ferroelectric layer 5, and that ferroelectric layer 5 is connected to two-dimensional material layer 1 with connection conductor 2e interposed therebetween.

Ferroelectric layer 5 is provided such that the polarization change of ferroelectric layer 5 caused by the electromagnetic wave irradiation is generated in a direction perpendicular to the bonding interface between two-dimensional material layer 1 and connection conductor 2e. In this case, the charge generated in ferroelectric layer 5 due to the polarization change is injected into two-dimensional material layer 1 through connection conductor 2e.

Connection conductor 2e and ferroelectric layer 5 in FIG. 37 are disposed on two-dimensional material layer 1. Connection conductor 2e and ferroelectric layer 5 may be disposed below two-dimensional material layer 1. In this case, for example, connection conductor 2e is disposed on ferroelectric layer 5. Ferroelectric layer 5 is provided such that the polarization change of ferroelectric layer 5 caused by the electromagnetic wave irradiation is generated in a direction perpendicular to the first surface of semiconductor layer 4.

Connection conductor 2e and ferroelectric layer 5 may be arranged side by side with two-dimensional material layer 1 in a direction along the first surface and orthogonal to the extending direction of two-dimensional material layer 1. In this case, ferroelectric layer 5 is preferably provided such that the polarization change of ferroelectric layer 5 caused by the electromagnetic wave irradiation is generated in a direction along the two-dimensional surface of two-dimensional material layer 1. In other words, ferroelectric layer 5 is provided such that the polarization change of ferroelectric layer 5 caused by the electromagnetic wave irradiation is generated in a direction along the first surface of semiconductor layer 4.

### Advantageous effect

The surface resistances of two-dimensional material layer 1 and ferroelectric layer 5 are high. Accordingly, when ferroelectric layer 5 is connected to two-dimensional material layer 1 without connection conductor 2e interposed therebetween, the charge generated by the polarization change in ferroelectric layer 5 is not injected into two-dimensional material layer 1. On the other hand, in the electromagnetic wave detector of the seventeenth embodiment, ferroelectric layer 5 is connected to two-dimensional material layer 1 with connection conductor 2e interposed there between. Accordingly, the charge generated by the polarization change accompanying the electromagnetic wave irradiation in ferroelectric layer 5 can be injected into two-dimensional material layer 1 through connection conductor 2e. As a result, in the electromagnetic wave detector of the seventeenth embodiment, the conductivity of two-dimensional material layer 1 can be efficiently modulated as compared with the electromagnetic wave detector in which ferroelectric layer 5 is connected to two-dimensional material layer 1 without connection conductor 2e interposed therebetween.

When connection conductor 2e and ferroelectric layer 5 are disposed on two-dimensional material layer 1, in the method for manufacturing the electromagnetic wave detector, the process of forming connection conductor 2e and ferroelectric layer 5 is performed after the process of forming two-dimensional material layer 1. Accordingly, two-dimensional material layer 1 may be damaged by the process of forming connection conductor 2e and ferroelectric layer 5.

On the other hand, when connection conductor 2e and ferroelectric layer 5 are disposed below two-dimensional material layer 1, in the method for manufacturing the electromagnetic wave detector, the process of forming connection conductor 2e and ferroelectric layer 5 is performed before the process of forming two-dimensional material layer 1. Accordingly, there is no possibility that two-dimensional material layer 1 is subjected to the process damage by the process of forming connection conductor 2e and ferroelectric layer 5. As a result, the decrease in the performance of two-dimensional material layer 1 due to the process damage and the decrease in the detection sensitivity of the electromagnetic wave detector can be prevented.

When connection conductor 2e and ferroelectric layer 5 are arranged side by side with two-dimensional material layer 1 in a direction along the first surface and orthogonal to the extending direction of two-dimensional material layer 1, ferroelectric layer 5 is preferably provided such that the polarization change of ferroelectric layer 5 caused by the electromagnetic wave irradiation is generated in a direction along the two-dimensional surface of two-dimensional material layer 1. The electrical resistance in the direction along the two-dimensional surface of two-dimensional material layer 1 is lower than the electrical resistance in the direction perpendicular to the two-dimensional surface of two-dimensional material layer 1. Accordingly, when ferroelectric layer 5 is provided such that the polarization change is generated in the direction along the two-dimensional surface of two-dimensional material layer 1, the charge generated by the polarization change accompanying the electromagnetic wave irradiation in ferroelectric layer 5 can be efficiently injected into two-dimensional material layer 1 through connection conductor 2e as compared with the case where ferroelectric layer 5 is provided such that the polarization change is generated in the direction perpendicular to the two-dimensional surface of two-dimensional material layer 1.

At this point, the configuration of the electromagnetic wave detector according to the tenth embodiment can also be applied to another embodiment.

### Eighteenth embodiment

### Configuration of electromagnetic wave detector

FIG. 38 is a schematic plan view illustrating an electromagnetic wave detector according to an eighteenth embodiment. FIG. 39 is a schematic sectional view illustrating a modification of the electromagnetic wave detector according to the eighteenth embodiment.

The electromagnetic wave detector illustrated in FIG. 38 is an electromagnetic wave detector assembly, and includes a plurality of electromagnetic wave detectors 100 according to any one of the first to twelfth embodiments as a detection element. For example, the electromagnetic wave detector according to the first embodiment may be used as electromagnetic wave detector 100. In FIG. 38, electromagnetic wave detectors 100 are arranged in an array in a two-dimensional direction. The plurality of electromagnetic wave detectors 100 may be arranged in a one-dimensional direction. The details will be described below.

As illustrated in FIG. 38, in the electromagnetic wave detector according to the eighteenth embodiment, electromagnetic wave detectors 100 are arranged in a 2 × 2 array. However, the number of electromagnetic wave detectors 100 to be arranged is not limited thereto. For example, the plurality of electromagnetic wave detectors 100 may be arranged in an array of greater than or equal to 3 × greater than or equal to 3. Furthermore, in the eighteenth embodiment, the plurality of electromagnetic wave detectors 100 is arrayed two-dimensionally and periodically, but the plurality of electromagnetic wave detectors 100 may be arrayed periodically along a certain direction. Furthermore, the plurality of electromagnetic wave detectors 100 may be arranged not periodically but at different intervals.

When the plurality of electromagnetic wave detectors 100 is arranged in an array, second electrode 2b may be a common electrode as long as each electromagnetic wave detector 100 can be separated. Using second electrode 2b as the common electrode, the number of wiring of pixels can be reduced as compared with the configuration in which second electrode 2b is independent in each electromagnetic wave detector 100. As a result, the resolution of the electromagnetic wave detector assembly can be increased.

As described above, the electromagnetic wave detector assembly using the plurality of electromagnetic wave detectors 100 can also be used as an image sensor by arranging the plurality of electromagnetic wave detectors 100 in an array.

In this case, in the eighteenth embodiment, the electromagnetic wave detector assembly including the plurality of electromagnetic wave detectors 100 according to the first embodiment has been described as an example. However, the electromagnetic wave detector of another embodiment may be used instead of the electromagnetic wave detector according to the first embodiment.

The electromagnetic wave detector illustrated in FIG. 39 is an electromagnetic wave detector assembly, basically has the same configuration as the electromagnetic wave detector illustrated in FIG. 38, and can obtain the same effect. However, the electromagnetic wave detector illustrated in FIG. 39 is different from the electromagnetic wave detector illustrated in FIG. 38 in that different types of electromagnetic wave detectors 200, 201, 202, 203 are used as a plurality of electromagnetic wave detectors. That is, in the electromagnetic wave detector illustrated in FIG. 39, electromagnetic wave detectors 200, 201, 202, 203 of different types are arranged in an array (matrix).

In FIG. 39, electromagnetic wave detectors 200, 201, 202, 203 are arranged in a 2 × 2 matrix, but the number of electromagnetic wave detectors to be arranged is not limited thereto. In the present embodiment, electromagnetic wave detectors 200, 201, 202, 203 of different types are periodically and two-dimensionally arrayed, but may be periodically and one-dimensionally arrayed. Furthermore, electromagnetic wave detectors 200, 201, 202, 203 of different types may be arranged not periodically but at different intervals.

In the electromagnetic wave detector assembly in FIG. 39, different types of electromagnetic wave detectors 200, 201, 202, 203 according to any one of the first to sixteenth embodiments are arranged in the one-dimensional or two-dimensional array, so that a function as an image sensor can be provided. For example, the electromagnetic wave detectors having different detection wavelengths may be used as electromagnetic wave detectors 200, 201, 202, 203. Specifically, the electromagnetic wave detectors having different detection wavelength selectivities may be prepared from the electromagnetic wave detector according to any one of the first to sixteenth embodiments, and arranged in an array. In this case, the electromagnetic wave detector assembly can detect the electromagnetic waves of at least two different wavelengths.

When electromagnetic wave detectors 200, 201, 202, 203 having different detection wavelengths are arrayed in this manner, the wavelength of the electromagnetic wave can be identified in an arbitrary wavelength region such as a wavelength region of ultraviolet light, infrared light, a terahertz wave, or a radio wave, similarly to the image sensor used in the visible light region. As a result, for example, a colored image in which a difference in wavelength is indicated as a difference in color can be obtained.

In addition, the materials having different detection wavelengths may be used as the constituent material of semiconductor layer 4 or ferroelectric layer 5 constituting the electromagnetic wave detector. For example, the semiconductor material in which the detection wavelength is a wavelength of visible light and the semiconductor material in which the detection wavelength is a wavelength of infrared light may be used as the above constituent material. In this case, for example, when the electromagnetic wave detector is applied to an in-vehicle sensor, the electromagnetic wave detector can be used as a visible light image camera in the daytime. Furthermore, the electromagnetic wave detector can also be used as an infrared camera at night. In this way, the camera having the image sensor is not required to be selectively used depending on the detection wavelength of the electromagnetic wave.

As an application of the electromagnetic wave detector other than the image sensor, for example, the electromagnetic wave detector can be used as a position detecting sensor capable of detecting the position of the object even with a small number of pixels. For example, the image sensor that detects intensity of the electromagnetic waves having the plurality of wavelengths can be obtained using electromagnetic wave detectors 200, 201, 202, 203 having different detection wavelengths as described above due to the structure of the electromagnetic wave detector assembly. Thus, the electromagnetic waves of the plurality of wavelengths can be detected to obtain the color image without using a color filter conventionally required in a CMOS image sensor or the like.

Furthermore, a polarization identification image sensor can also be formed by arraying electromagnetic wave detectors 200, 201, 202, 203 having different polarizations to be detected. For example, the polarization imaging can be performed by arranging a plurality of electromagnetic wave detectors in one unit of four pixels in which detected polarization angles are 0°, 90°, 45°, 135°. For example, the polarization identification image sensor enables identification of an artifact and a natural object, material identification, identification of an object having the same temperature in an infrared wavelength range, identification of a boundary between objects, or improvement of equivalent resolution.

As described above, the electromagnetic wave detector assembly according to the eighteenth embodiment configured as described above can detect the electromagnetic wave in the wide wavelength range. Furthermore, the electromagnetic wave detector assembly according to the eighteenth embodiment can detect the electromagnetic waves of different wavelengths.

### Advantageous effect

The electromagnetic detector assembly described above includes the plurality of electromagnetic wave detectors. The plurality of electromagnetic wave detectors 200, 201, 202, 203 may be different types of electromagnetic wave detectors. For example, the plurality of electromagnetic wave detectors 200, 201, 202, 203 may have different detection wavelengths. In this case, electromagnetic waves of different wavelengths can be detected by one electromagnetic wave detector assembly.

In each of the embodiments described above, a material in which a characteristic is changed by the electromagnetic wave irradiation to impart the change in potential to two-dimensional material layer 1 may be used as the material of insulating film 3, contact layer 8, or semiconductor layer 4.

For example, quantum dots, ferroelectric materials, liquid crystal materials, fullerenes, rare earth oxides, semiconductor materials, pn junction materials, metal-semiconductor junction materials, or metal-insulator-semiconductor junction materials can be used as a material in which the characteristic is changed by the electromagnetic wave irradiation to impart the change in potential to two-dimensional material layer 1. For example, when the ferroelectric material having the polarization effect (pyroelectric effect) due to the electromagnetic wave is used as the ferroelectric material, the polarization of the ferroelectric material is changed by the electromagnetic wave irradiation. As a result, the change in potential can be applied to two-dimensional material layer 1.

When the material as described above is used as the material such as insulating film 3 as described above, the characteristic of insulating film 3, contact layer 8, or semiconductor layer 4 is changed by the electromagnetic wave irradiation. As a result, the change in potential can be applied to two-dimensional material layer 1.

The material in which the characteristic is changed by the electromagnetic wave irradiation to impart the change in potential to the two-dimensional material layer 1 is applied to insulating film 3, contact layer 8, or semiconductor layer 4 has been described as the example. However, the material in which the characteristic is changed by the electromagnetic wave irradiation to impart the change in potential to two-dimensional material layer 1 may be applied to at least one of the above-described members. For example, when the material in which the characteristic is changed by irradiation of contact layer 8 with electromagnetic waves to impart the change in potential to two-dimensional material layer 1 is applied, contact layer 8 is not necessarily in direct contact with two-dimensional material layer 1. For example, as long as the change in potential can be applied to two-dimensional material layer 1, contact layer 8 may be provided on the upper surface or the lower surface of two-dimensional material layer 1 with the insulating film or the like interposed therebetween.

It should be considered that the disclosed embodiments are an example in all respects and not restrictive. As long as there is no contradiction, at least two of the disclosed embodiments may be combined. The scope of the present invention is defined by not the above description but the claims, and it is intended that all modifications within the meaning and scope of the claims are included in the present invention.

### LIST OF REFERENCE SIGNS

- 1: two-dimensional material layer
- 2a: first electrode
- 2b, 2ba: second electrode
- 2bb: fourth electrode
- 2c: third electrode
- 2d: connection conductor
- 3, 3b: insulating film
- 4, 4a, 4b: semiconductor layer
- 5, 5a, 5b: ferroelectric layer
- 6: tunnel insulating layer
- 7: conductor
- 8: contact layer
- 9: void
- 100, 200, 201, 202, 203: electromagnetic wave detector

## Claims

1. An electromagnetic wave detector comprising:
a semiconductor layer;
a two-dimensional material layer electrically connected to the semiconductor layer;
a first electrode electrically connected to the two-dimensional material layer without the semiconductor layer interposed therebetween;
a second electrode electrically connected to the two-dimensional material layer with the semiconductor layer interposed therebetween; and
a ferroelectric layer,
wherein the ferroelectric layer is in contact with at least a part of the two-dimensional material layer, or is disposed at a distance from the two-dimensional material layer and overlaps with at least a part of the two-dimensional material layer.

2. The electromagnetic wave detector according to claim 1, further comprising an insulating film that is in contact with a part of the semiconductor layer, and forms an opening that opens another part of the semiconductor layer, wherein the two-dimensional material layer is electrically connected to the other part of the semiconductor layer in the opening, and extends from above the opening to above the insulating film.

3. The electromagnetic wave detector according to claim 1, wherein the ferroelectric layer is disposed at a distance from the two-dimensional material layer such that a resistance value of the two-dimensional material layer changes when polarization in the ferroelectric layer changes.

4. The electromagnetic wave detector according to claim 3, further comprising an insulating film to separate at least a part of the two-dimensional material layer from the ferroelectric layer.

5. The electromagnetic wave detector according to claim 3, further comprising a connection conductor to electrically connect the two-dimensional material layer to the ferroelectric layer,
wherein the ferroelectric layer is electrically connected to the two-dimensional material layer with the connection conductor interposed therebetween.

6. The electromagnetic wave detector according to any one of claims 1 to 5, wherein the two-dimensional material layer includes a first portion that is in contact with the semiconductor layer or a conductive member electrically connected to the semiconductor layer, and
at least a part of the two-dimensional material layer includes the first portion.

7. The electromagnetic wave detector according to any one of claims 1 to 6, wherein the two-dimensional material layer includes the first portion that is in contact with the semiconductor layer or the conductive member electrically connected to the semiconductor layer, a second portion that is in contact with the first electrode, and a third portion electrically connecting the first portion to the second portion, and
at least a part of the two-dimensional material layer includes the third portion.

8. The electromagnetic wave detector according to claim 6 or 7, wherein at least a part of the two-dimensional material layer includes only the first portion or the third portion.

9. The electromagnetic wave detector according to any one of claims 6 to 8, wherein the first portion or the conductive member forms a Schottky junction with the semiconductor layer.

10. The electromagnetic wave detector according to any one of claims 6 to 9, wherein the first electrode is formed in an annular shape in planar view, and the first portion is disposed inside the first electrode.

11. The electromagnetic wave detector according to any one of claims 6 to 10, wherein the first portion has an end of the two-dimensional material layer in planar view.

12. The electromagnetic wave detector according to any one of claims 1 to 11, wherein the ferroelectric layer is disposed on a side opposite to the semiconductor layer with respect to the two-dimensional material layer.

13. The electromagnetic wave detector according to any one of claims 1 to 11, wherein the ferroelectric layer is disposed on a side of the semiconductor layer with respect to the two-dimensional material layer.

14. The electromagnetic wave detector according to any one of claims 1 to 13, further comprising a third electrode in contact with the ferroelectric layer.

15. The electromagnetic wave detector according to any one of claims 1 to 14, wherein the semiconductor layer, the two-dimensional material layer, the first electrode, and the second electrode are disposed on the ferroelectric layer.

16. The electromagnetic wave detector according to any one of claims 1 to 15, further comprising a tunnel insulating layer disposed between the two-dimensional material layer and the semiconductor layer.

17. The electromagnetic wave detector according to claim 16, wherein a thickness of the tunnel insulating layer is set such that a tunnel current is generated between the two-dimensional material layer and the semiconductor layer when an electromagnetic wave to be detected is incident on the two-dimensional material layer and the ferroelectric layer.

18. The electromagnetic wave detector according to any one of claims 1 to 17, further comprising a connection conductor to electrically connect the two-dimensional material layer to the semiconductor layer.

19. The electromagnetic wave detector according to any one of claims 1 to 18, wherein a polarization direction of the ferroelectric layer is a direction perpendicular to an extending direction of the two-dimensional material layer.

20. The electromagnetic wave detector according to any one of claims 1 to 19, wherein the two-dimensional material layer includes a region in contact with the ferroelectric layer and a region in contact with the semiconductor layer, and
the ferroelectric layer is provided so as to generate an electric field in a direction perpendicular to an extending direction of the two-dimensional material layer in at least one of the region in contact with the ferroelectric layer of the two-dimensional material layer and the region in contact with the semiconductor layer.

21. The electromagnetic wave detector according to any one of claims 1 to 20, wherein a plurality of at least one of a connection portion between the two-dimensional material layer and the first electrode and a connection portion between the two-dimensional material layer and the semiconductor layer are provided.

22. The electromagnetic wave detector according to any one of claims 1 to 21, wherein the ferroelectric layer includes a first ferroelectric portion and a second ferroelectric portion, and
an electromagnetic wave absorption wavelength of a material constituting the first ferroelectric portion is different from an electromagnetic wave absorption wavelength of a material constituting the second ferroelectric portion.

23. The electromagnetic wave detector according to any one of claims 1 to 22, wherein the ferroelectric layer includes a first ferroelectric portion and a second ferroelectric portion,
each of the first ferroelectric portion and the second ferroelectric portion is disposed so as to overlap with at least a part of the two-dimensional material layer, and
a polarizability of the material constituting the first ferroelectric portion is different from a polarizability of the material constituting the second ferroelectric portion.

24. The electromagnetic wave detector according to any one of claims 1 to 23, wherein the semiconductor layer includes a first semiconductor portion of a first conductivity type and a second semiconductor portion of a second conductivity type,
the two-dimensional material layer is electrically connected to the first semiconductor portion, and
the second electrode is electrically connected to the two-dimensional material layer with the second semiconductor portion interposed therebetween.

25. The electromagnetic wave detector according to claim 24, further comprising a fourth electrode electrically connected to the first semiconductor portion,
wherein the two-dimensional material layer is electrically connected to the first semiconductor portion and the second semiconductor portion.

26. The electromagnetic wave detector according to any one of claims 1 to 25, wherein the two-dimensional material layer includes a turbulent layer structure.

27. The electromagnetic wave detector according to any one of claims 1 to 26, further comprising at least one conductor or contact layer that is disposed so as to contact the two-dimensional material layer.

28. The electromagnetic wave detector according to any one of claims 1 to 27, wherein a void is formed around the two-dimensional material layer, and the two-dimensional material layer has a surface facing the void.

29. The electromagnetic wave detector according to any one of claims 1 to 28, wherein the two-dimensional material layer includes any material selected from a group consisting of transition metal di-chalcogenide, graphene, black phosphorus, silicene, germanene, graphene nanoribbons, and borophene.

30. The electromagnetic wave detector according to any one of claims 1 to 29, wherein the first electrode, the two-dimensional material layer, the semiconductor layer, and the second electrode are electrically connected in order of the first electrode, the two-dimensional material layer, the semiconductor layer, and the second electrode, and
the electromagnetic wave to be detected is detected as a change in a current value flowing between the first electrode and the second electrode.

31. An electromagnetic wave detector array comprising a plurality of the electromagnetic wave detectors according to any one of claims 1 to 30, wherein the plurality of electromagnetic wave detectors are arranged side by side along at least one of a first direction and a second direction.
